# EUROPEAN PATENT SPECIFICATION

(11) **EP 4 583 669 B1**
(45) Date of publication and mention of the grant of the patent: **04.11.2026**
(21) Application number: 24198146.3
(22) Date of filing: 03.09.2024
(51) Int. Cl.: H10F 39/18, H10F 39/00

(54) **IMAGE SENSOR HAVING NANO-PHOTONIC LENS ARRAY AND ELECTRONIC APPARATUS INCLUDING THE IMAGE SENSOR**
BILDSENSOR MIT NANOPHOTONISCHER LINSENANORDNUNG UND ELEKTRONISCHE VORRICHTUNG MIT DEM BILDSENSOR
CAPTEUR D'IMAGE AYANT UN RÉSEAU DE LENTILLES NANOPHOTONIQUES ET APPAREIL ÉLECTRONIQUE COMPRENANT LE CAPTEUR D'IMAGE

(30) Priority: 08.01.2024 KR 20240003123
(43) Date of publication of application: 09.07.2025
(73) Proprietor: Samsung Electronics Co., Ltd., Suwon-si, Gyeonggi-do 16677 (KR)
(72) Inventor: ROH, Sookyoung, 16678 Suwon-si (KR); JANG, Soongeun, 16678 Suwon-si (KR); AHN, Sungmo, 16678 Suwon-si (KR); YUN, Seokho, 16678 Suwon-si (KR); LEE, Junho, 16678 Suwon-si (KR)
(74) Representative: Elkington and Fife LLP

(56) References cited:
- US-A1- 2022 326 415
- US-A1- 2023 115 006

## Description

### FIELD OF THE INVENTION

The disclosure relates to an image sensor including a nano-photonic lens array and an electronic apparatus including the image sensor.

### BACKGROUND OF THE INVENTION

Image sensors may sense the color of incident light by using a color filter. However, a color filter may have low light utilization efficiency because the color filter absorbs light of colors other than the intended color of light. For example, in the case in which a red-green-blue (RGB) color filter is used, only 1/3 of the incident light is transmitted therethrough and the other part of the incident light, that is, 2/3 of the incident light, is absorbed. Thus, the light utilization efficiency is only about 33%. Thus, in a color display apparatus or a color image sensor, most light loss occurs in the color filter.

Also, an image sensor according to the related art has a structure in which pixels sensing light of different colors are periodically arranged, and thus, information on same color cannot be obtained from every region on the image sensor. Therefore, resolution degradation may occur due to under-sampling, and artifacts may be generated during image processing for reconstructing lost color information. Document US 2022/326415 A1 shows an image sensor comprising a nano-photonic lens array according to the prior-art.

### SUMMARY OF THE INVENTION

Provided are an image sensor including a nano-photonic lens array and having improved optical efficiency, and an electronic apparatus including the image sensor.

Provided are an image sensor including a nano-photonic lens array configured not to require demosaicing during image processing, and an electronic apparatus including the image sensor.

Additional aspects will be set forth in part in the description which follows and, in part, will be apparent from the description, or may be learned by practice of example embodiments of the disclosure.

According to an aspect of an example embodiment, there is provided an image sensor including a sensor substrate including a plurality of unit pixel patterns that include a first pixel, a second pixel, a third pixel, and a fourth pixel configured to sense light, the plurality of unit pixel patterns being two-dimensionally provided in a first direction and a second direction, and a nano-photonic lens array including a plurality of unit meta-patterns that include a first meta-region, a second meta-region, a third meta-region, and a fourth meta-region respectively corresponding to the first pixel, the second pixel, the third pixel, and the fourth pixel, the plurality of unit meta-patterns being two-dimensionally provided in the first direction and the second direction, wherein each of the first meta-region, the second meta-region, the third meta-region, and the fourth meta-region includes a plurality of nano-structures that are configured to color-separate light incident on each unit meta-pattern of the plurality of unit meta-patterns included in the nano-photonic lens array and to condense the color-separated light onto the first pixel, the second pixel, the third pixel, and the fourth pixel, wherein, in each unit meta-pattern from among the plurality of unit meta-patterns, a distribution of cross-sectional areas of the plurality of nano-structures is asymmetrical in the first direction, the second direction, a first diagonal line direction, and a second diagonal line direction with respect to a center of each unit meta-pattern of the plurality of unit meta-patterns, and wherein, in each unit meta-pattern from among the plurality of unit meta-patterns, the distribution of the cross-sectional areas of the plurality of nano-structures in the first meta-region and the distribution of the cross-sectional areas of the plurality of nano-structures in the fourth meta-region are in a 180□-angle rotational symmetric relationship with respect to the center of each unit meta-pattern of the plurality of unit meta-patterns.

Heights, positions, and periods of the plurality of nano-structures included in the first meta-region, the second meta-region, the third meta-region, and the fourth meta-region may be equal to each other.

The distribution of the cross-sectional areas of the plurality of nano-structures in the first meta-region, a distribution of the cross-sectional areas of the plurality of nano-structures in the second meta-region, a distribution of the cross-sectional areas of the plurality of nano-structures in the third meta-region, and the distribution of the cross-sectional areas of the plurality of nano-structures in the fourth meta-region may be determined such that color-separation and condensation of light occur independently in each unit meta-pattern from among the plurality of unit meta-patterns without light exchange being generated among the plurality of unit meta-patterns.

The distribution of the cross-sectional areas of the plurality of nano-structures in the first meta-region may be asymmetrical in the first direction, the second direction, the first diagonal line direction, and the second diagonal line direction with respect to the center of the first meta-region, and the distribution of the cross-sectional areas of the plurality of nano-structures in the fourth meta-region may be asymmetrical in the first direction, the second direction, the first diagonal line direction, and the second diagonal line direction with respect to the center of the first meta-region.

From among the plurality of nano-structures in the first meta-region, a phase delay of light transmitted by a nano-structure adjacent to the second meta-region and a phase delay of light transmitted by a nano-structure adjacent to the third meta-region may be greater than phase delays of light transmitted by the other nano-structures, and from among the plurality of nano-structures in the fourth meta-region, a phase delay of light transmitted by a nano-structure adjacent to the second meta-region and a phase delay of light transmitted by a nano-structure adjacent to the third meta-region may be greater than phase delays of light transmitted by the other nano-structures.

From among a plurality of pairs of two nano-structures facing each other in the second direction with respect to a horizontal center line passing through the center of the first meta-region in the first direction, cross sectional areas of at least one pair of nano-structures may be different from each other, from among a plurality of pairs of two nano-structures facing each other in the first direction with respect to a vertical center line passing through the center of the first meta-region in the second direction, cross sectional areas of at least one pair of nano-structures may be different from each other, from among a plurality of pairs of two nano-structures facing each other with respect to the first diagonal line passing through the center of the first meta-region, cross sectional areas of at least one pair of nano-structures may be different from each other, from among a plurality of pairs of two nano-structures facing each other with respect to the second diagonal line passing through the center of the first meta-region, cross sectional areas of at least one pair of nano-structures may be different from each other, and cross sectional areas of two nano-structures that are adjacent to a unit meta-pattern different from the unit meta-pattern including the first meta-region and face each other based on the second diagonal line may be equal to each other.

From among a plurality of pairs of two nano-structures facing each other in the second direction with respect to a horizontal center line passing through the center of the fourth meta-region in the first direction, cross sectional areas of at least one pair of nano-structures may be different from each other, from among a plurality of pairs of two nano-structures facing each other in the first direction with respect to a vertical center line passing through the center of the fourth meta-region in the second direction, cross sectional areas of at least one pair of nano-structures have may be different from each other, from among a plurality of pairs of two nano-structures facing each other with respect to the first diagonal line passing through the center of the fourth meta-region, cross sectional areas of at least one pair of nano-structures may be different from each other, and from among a plurality of pairs of two nano-structures facing each other with respect to the second diagonal line passing through the center of the fourth meta-region, cross sectional areas of at least one pair of nano-structures may be different from each other.

Cross sectional areas of two nano-structures that are adjacent to a unit meta-pattern different from the unit meta-pattern including the fourth meta-region and face each other based on the second diagonal line may be equal to each other.

In the second meta-region, the distribution of cross-sectional areas of the plurality of nano-structures may be symmetrical in the first diagonal line direction and asymmetrical in the first direction, the second direction, and the second diagonal line direction based on a center of the second meta-region, and in the third meta-region, the distribution of cross-sectional areas of the plurality of nano-structures may be symmetrical in the first diagonal line direction and asymmetrical in the first direction, the second direction, and the second diagonal line direction based on a center of the third meta-region.

From among the plurality of nano-structures in the second meta-region, a phase delay of light transmitted by a nano-structure adjacent to the first meta-region and a phase delay of light transmitted by a nano-structure adjacent to the fourth meta-region may be greater than phase delays of light transmitted by the other nano-structures, and from among the plurality of nano-structures in the third meta-region, a phase delay of light transmitted by a nano-structure adjacent to the first meta-region and a phase delay of light transmitted by a nano-structure adjacent to the fourth meta-region may be greater than phase delays of light transmitted by the other nano-structures.

In the second meta-region, cross sectional areas of two nano-structures facing each other with respect to the first diagonal line passing through the center of the second meta-region may be equal to each other.

From among a plurality of pairs of two nano-structures facing each other in the second direction with respect to a horizontal center line passing through the center of the second meta-region in the first direction, cross sectional areas of at least one pair of nano-structures may be different from each other, from among a plurality of pairs of two nano-structures facing each other in the first direction with respect to a vertical center line passing through the center of the second meta-region in the second direction, cross sectional areas of at least one pair of nano-structures may be different from each other, and from among a plurality of pairs of two nano-structures facing each other with respect to the second diagonal line passing through the center of the second meta-region, cross sectional areas of at least one pair of nano-structures may be different from each other.

In the third meta-region, cross sectional areas of two nano-structures facing each other with respect to the first diagonal line passing through the center of the third meta-region may be equal to each other, from among a plurality of pairs of two nano-structures facing each other in the second direction with respect to a horizontal center line passing through the center of the third meta-region in the first direction, cross sectional areas of at least one pair of nano-structures may be different from each other, from among a plurality of pairs of two nano-structures facing each other in the first direction with respect to a vertical center line passing through the center of the third meta-region in the second direction, cross sectional areas of at least one pair of nano-structures may be different from each other, and from among a plurality of pairs of two nano-structures facing each other with respect to the second diagonal line passing through the center of the third meta-region, cross sectional areas of at least one pair of nano-structures may be different from each other.

In the unit meta-pattern, phase delays of light transmitted by the nano-structures at a center portion of the unit meta-pattern are configured may be greater phase delays than phase delays of light transmitted by the nano-structures that are directly adjacent to another unit meta-pattern.

The plurality of nano-structures may be configured to color-separate light incident on each unit meta-pattern in the nano-photonic lens array, and to condense light of a first wavelength band onto the first pixel and the fourth pixel, light of a second wavelength band onto the second pixel, and light of a third wavelength band onto the third pixel, in one unit pixel pattern, the second pixel and the third pixel may be provided in the first diagonal line direction, and the first pixel and the fourth pixel are provided in the second diagonal line direction crossing the first diagonal line direction, and in one unit meta-pattern, the second meta-region and the third meta-region may be provided in the first diagonal line direction and the first meta-region and the fourth meta-region are provided in the second diagonal line direction.

The image sensor may further include a plurality of isolation patterns on an upper surface of the nano-photonic lens array, wherein each of the plurality of isolation patterns faces the first meta-region, the second meta-region, the third meta-region, and the fourth meta-region included in a corresponding unit meta-pattern from among the plurality of unit meta-patterns.

Each isolation pattern from among the plurality of isolation patterns may have a flat upper surface, an irregularly uneven upper surface, or a convex upper surface.

The image sensor, in each unit pixel pattern from among the plurality of unit pixel patterns, may be configured to generate a luminance signal by summing an output from the first pixel, an output from the second pixel, an output from the third pixel, and an output from the fourth pixel, generate a first color signal by subtracting the output from the first pixel and the output from the fourth pixel from the output from the third pixel, and generate a second color signal by subtracting the output from the first pixel and the output from the fourth pixel from the output from the second pixel.

The image sensor may be further configured to convert the luminance signal, the first color signal, and the second color signal into digital signals, selectively generate image data having one of a plurality of digital image formats based on a digitalized luminance signal, the first color signal, and the second color signal, and output the image data external to the image sensor.

According to another aspect of an example embodiment, there is provided an electronic apparatus including a lens assembly configured to form an optical image of a subject, an image sensor configured to convert, into an electrical signal, the optical image formed by the lens assembly, and a processor configured to process the electrical signal generated by the image sensor, wherein the image sensor includes a sensor substrate including a plurality of unit pixel patterns that include a first pixel, a second pixel, a third pixel, and a fourth pixel sensing light, the plurality of unit pixel patterns being two-dimensionally provided in a first direction and a second direction, and a nano-photonic lens array including a plurality of unit meta-patterns that include a first meta-region, a second meta-region, a third meta-region, and a fourth meta-region respectively corresponding to the first pixel, the second pixel, the third pixel, and the fourth pixel, the plurality of unit meta-patterns being two-dimensionally provided in the first direction and the second direction, wherein each of the first meta-region, the second meta-region, the third meta-region, and the fourth meta-region includes a plurality of nano-structures that are configured to color-separate light incident on each unit meta-pattern from among the plurality of unit meta-patterns in the nano-photonic lens array and to condense the color-separated light onto the first pixel, the second pixel, the third pixel, and the fourth pixel, wherein, in each unit meta-pattern from among the plurality of unit meta-patterns, a distribution of cross-sectional areas of the plurality of nano-structures is asymmetrical in the first direction, the second direction, a first diagonal line direction, and a second diagonal line direction with respect to a center of each of the plurality of unit meta-patterns, and wherein, in each unit meta-pattern of the plurality of unit meta-patterns, the distribution of the cross-sectional areas of the plurality of nano-structures in the first meta-region and the distribution of the cross-sectional areas of the plurality of nano-structures in the fourth meta-region are in a 180□-angle rotational symmetric relationship with respect to the center of each unit meta-pattern of the plurality of unit meta-patterns.

According to another aspect of an example embodiment, there is provided an image sensor including a sensor substrate including a plurality of unit pixel patterns that include a first pixel, a second pixel, a third pixel, and a fourth pixel configured to sense light, the plurality of unit pixel patterns being two-dimensionally provided in a first direction and a second direction, and a nano-photonic lens array including a plurality of unit meta-patterns that include a first meta-region, a second meta-region, a third meta-region, and a fourth meta-region respectively corresponding to the first pixel, the second pixel, the third pixel, and the fourth pixel, the plurality of unit meta-patterns being two-dimensionally provided in the first direction and the second direction, wherein each of the first meta-region, the second meta-region, the third meta-region, and the fourth meta-region includes a plurality of nano-structures that are configured to color-separate light incident on each unit meta-pattern of the plurality of unit meta-patterns included in the nano-photonic lens array and to condense the color-separated light onto the first pixel, the second pixel, the third pixel, and the fourth pixel, wherein, in each unit meta-pattern from among the plurality of unit meta-patterns, a distribution of cross-sectional areas of the plurality of nano-structures is asymmetrical in the first direction, the second direction, a first diagonal line direction, and a second diagonal line direction with respect to a center of each unit meta-pattern of the plurality of unit meta-patterns, and wherein color-separation and condensation of light occur independently in each unit meta-pattern from among the plurality of unit meta-patterns without light exchange being generated among the plurality of unit meta-patterns based on the distribution of the cross-sectional areas of the plurality of nano-structures in the first meta-region, a distribution of the cross-sectional areas of the plurality of nano-structures in the second meta-region, a distribution of the cross-sectional areas of the plurality of nano-structures in the third meta-region, and the distribution of the cross-sectional areas of the plurality of nano-structures in the fourth meta-region.

### BRIEF DESCRIPTION OF DRAWINGS

The above and other aspects, features, and advantages of example embodiments of the disclosure will be more apparent from the following description taken in conjunction with the accompanying drawings, in which:
FIG. 1 is a schematic block diagram of an image sensor according to an example embodiment;
FIG. 2 is a diagram showing an example of a pixel arrangement in a pixel array of an image sensor;
FIGS. 3A and 3B are cross-sectional views schematically showing a structure of a pixel array in an image sensor according to an example embodiment;
FIG. 4A is a plan view schematically showing a pixel arrangement of a sensor substrate in the pixel array of FIGS. 3A and 3B;
FIG. 4B is a plan view schematically showing another pixel arrangement of a sensor substrate in the pixel array of FIGS. 3A and 3B;
FIG. 5 is a plan view showing an example of an arrangement of a plurality of nano-structures in one unit meta-pattern in the nano-photonic lens array of FIGS. 3A and 3B;
FIG. 6 is a diagram showing a plurality of different nano-structures indicated by reference numerals, the nano-structures being arranged in first to fourth meta-regions of one unit meta-pattern in the nano-photonic lens array;
FIG. 7 is a distribution diagram showing a phase profile of blue light that has passed through the nano-photonic lens array;
FIG. 8 is a graph showing an example of a phase profile of blue light on a cross-section taken alone line A1-A1' of FIG. 7;
FIG. 9 is a distribution diagram showing an example of a phase profile of green light that has passed through the nano-photonic lens array;
FIG. 10A is a graph showing an example of a phase profile of green light on a cross-section taken along line A2-A2' of FIG. 9;
FIG. 10B is a graph showing an example of a phase profile of green light on a cross-section taken along line A3-A3' of FIG. 9;
FIG. 11 is a distribution diagram showing a phase profile of red light that has passed through the nano-photonic lens array;
FIG. 12 is a graph showing an example of a phase profile of red light on a cross-section taken alone line A4-A4' of FIG. 11;
FIG. 13 is a graph showing a light utilization efficiency of an image sensor according to an embodiment versus a light utilization efficiency of an image sensor according to a related example;
FIG. 14 is a plan view showing an example of an arrangement of a plurality of nano-structures in one meta-pattern of a nano-photonic lens array according to another example embodiment;
FIGS. 15A and 15B are cross-sectional views schematically showing a structure of a pixel array in an image sensor according to another example embodiment;
FIG. 16 is a cross-sectional view schematically showing a structure of a pixel array in an image sensor according to another example embodiment;
FIG. 17 is a cross-sectional view schematically showing a structure of a pixel array in an image sensor according to another example embodiment;
FIG. 18 is a cross-sectional view schematically showing a structure of a pixel array in an image sensor according to another example embodiment;
FIG. 19 is a cross-sectional view schematically showing a structure of a pixel array in an image sensor according to another example embodiment;
FIGS. 20 to 22 are diagrams showing examples of various pixel arrangements in a pixel array of an image sensor according to another example embodiment;
FIG. 23 is a flowchart schematically illustrating image processing according to an example embodiment;
FIG. 24 is a diagram showing an example of image processing by an image sensor in a pre-process of FIG. 23;
FIGS. 25A, 25B, and 25C are diagrams showing examples of image formats of FIG. 24;
FIG. 26 is a diagram showing another example of image processing in the pre-process of FIG. 23;
FIG. 27 is a block diagram of an electronic device including an image sensor according to an example embodiment;
FIG. 28 is a block diagram of a camera module in FIG. 27;
FIG. 29 is a block diagram of an electronic device including a multi-camera module; and
FIG. 30 is a detailed block diagram of the multi-camera module in the electronic device of FIG. 29.

### DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, an image sensor including a nano-photonic lens array and an electronic apparatus including the image sensor will be described in detail with reference to accompanying drawings. The example embodiments of the disclosure are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

In addition, the terms such as "... unit", "module", etc. provided herein indicates a unit performing a function or operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe a technical detail, and the scope of rights is not limited by these terms unless the context is limited by the claims.

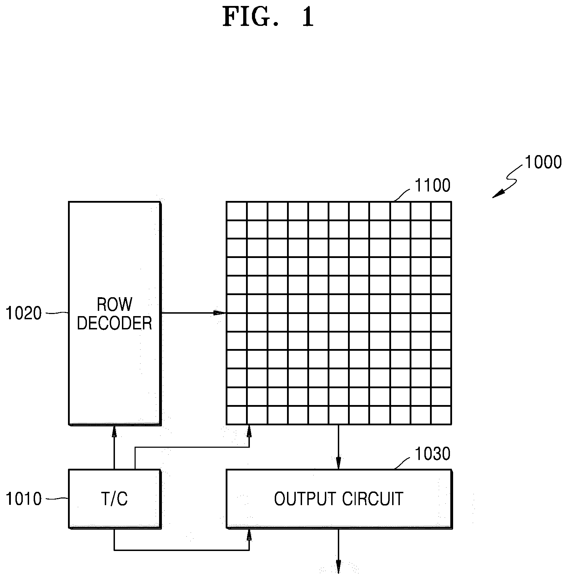

FIG. 1 is a schematic block diagram of an image sensor 1000 according to an embodiment. Referring to FIG. 1, the image sensor 1000 may include a pixel array 1100, a timing controller (T/C) 1010, a row decoder 1020, and an output circuit 1030. The image sensor 1000 may be a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 may select one of the rows in the pixel array 1100 in response to a row address signal output from the timing controller 1010. The output circuit 1030 may output a photosensitive signal from a plurality of pixels disposed in the selected row in a column unit. To this end, the output circuit 1030 may include a column decoder and an analog-to-digital converter (ADC). For example, the output circuit 1030 may include a plurality of ADCs that are respectively disposed in columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

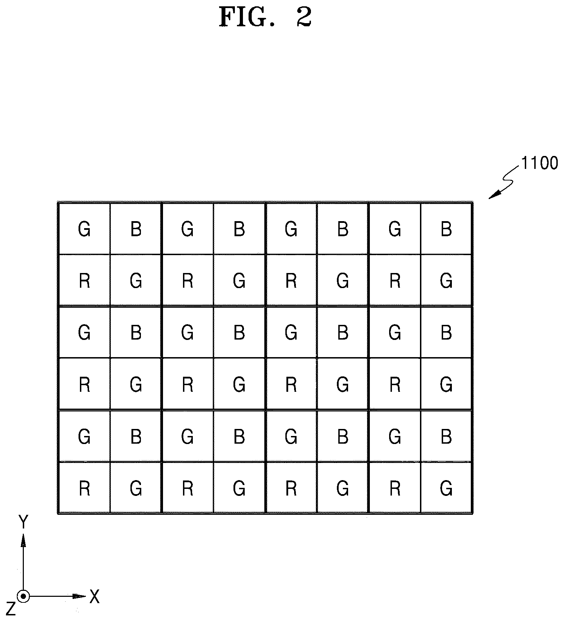

The pixel array 1100 may include a plurality of pixels that sense light of different wavelengths. The pixel arrangement may be implemented in various ways. FIG. 2 is a diagram showing an example of a pixel arrangement in a pixel array of the image sensor 1000. In particular, FIG. 2 shows an arrangement of Bayer pattern that is generally used in the image sensor 1000.

Referring to FIG. 2, one unit pixel pattern includes four quadrant regions, and first through fourth quadrants may be the blue pixel B, the green pixel G, the red pixel R, and the green pixel G, respectively. The unit pixel patterns are repeatedly two-dimensionally arranged in a first direction (an X direction) and a second direction (a Y direction) perpendicular to the first direction. For example, two green pixels G are disposed in one diagonal line direction and one blue pixel B and one red pixel R are disposed in another diagonal line direction in a unit pixel pattern of a 2×2 array. In the entire arrangement of pixels, a first row in which a plurality of green pixels G and a plurality of blue pixels B are alternately disposed in the first direction and a second row in which a plurality of red pixels R and a plurality of green pixels G are alternately disposed in the first direction are repeatedly disposed in a second direction. The pixel array 1100 may have various arrangement patterns, rather than the Bayer pattern. Hereinafter, an example in which the pixel array 1100 of the image sensor 1000 has a Bayer pattern structure shown in FIG. 2 is described below.

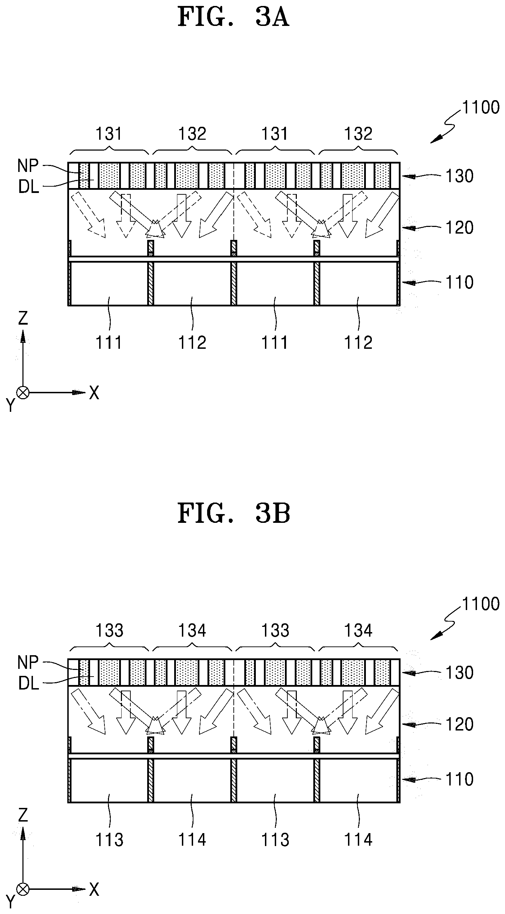

FIGS. 3A and 3B are cross-sectional views schematically showing a structure of the pixel array 1100 in the image sensor 1000 according to an example embodiment. FIG. 3A shows a cross-section of the pixel array 1100 taken along the first direction (X-direction), and FIG. 3B shows a cross-section of the pixel array 1100, taken along the first direction (X-direction) at a location different from that of FIG. 3A in the second direction (Y-direction). Referring to FIGS. 3A and 3B, the pixel array 1100 may include a sensor substrate 110, a spacer layer 120 on the sensor substrate 110, and a nano-photonic lens array 130 on the spacer layer 120.

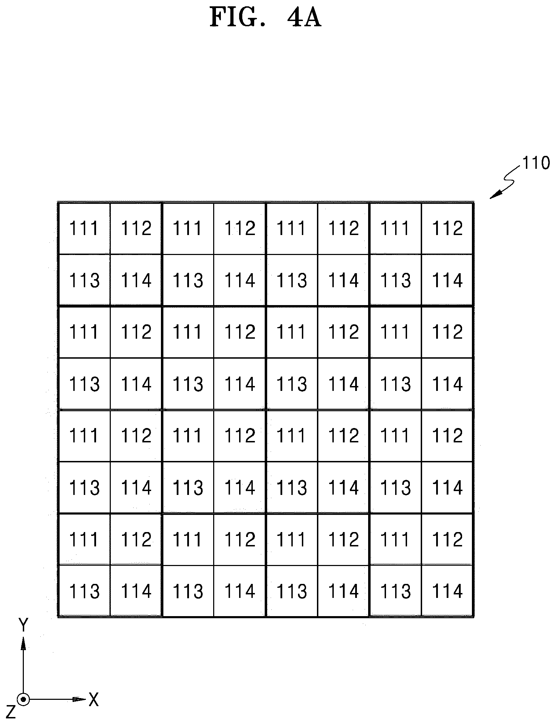

FIG. 4A is a plan view schematically showing pixel arrangement of a sensor substrate 110 in the pixel array 1100 of FIGS. 3A and 3B. Referring to FIG. 4A, the sensor substrate 110 may include a plurality of pixels sensing incident light. For example, the sensor substrate 110 may include a plurality of first pixels 111, a plurality of second pixels112, a plurality of third pixels 113, and a plurality of fourth pixels 114 that convert incident light into electrical signals and generate an image signal.

One first pixel 111, one second pixel 112, one third pixel 113, and one fourth pixel 114 arranged in a group of 2x2 array may form one unit pixel pattern. **In** the sensor substrate 110, a plurality of unit pixel patterns each including the first pixel 111, the second pixel 112, the third pixel 113, and the fourth pixel 114 may be periodically repeated and two-dimensionally arranged in the first direction (X-direction) and the second direction (Y-direction). For example, a plurality of first pixels 111 and a plurality of second pixels 112 may be alternately disposed in the first direction, and a plurality of third pixels 113 and a plurality of fourth pixels 114 may be alternately disposed in the first direction on a cross-section located differently in the second direction that is perpendicular to the first direction. Also, the plurality of second pixels 112 and the plurality of third pixels 113 may be arranged in a first diagonal line direction and the plurality of first pixels 111 and the plurality of fourth pixels 114 may be arranged in a second diagonal line direction crossing the first diagonal line direction. **In** an example, the first and fourth pixels 111 and 114 may be green pixels sensing green light, the second pixel 112 may be a blue pixel sensing blue light, and the third pixel 113 may be a red pixel sensing red light.

In an example, each of the first to fourth pixels 111, 112, 113, and 114 may include one photosensitive cell. For example, each of the first to fourth pixels 111, 112, 113, and 114 may include one photodiode. In this case, each of the first to fourth photosensitive cells 111, 112, 113, and 114 may output only one signal.

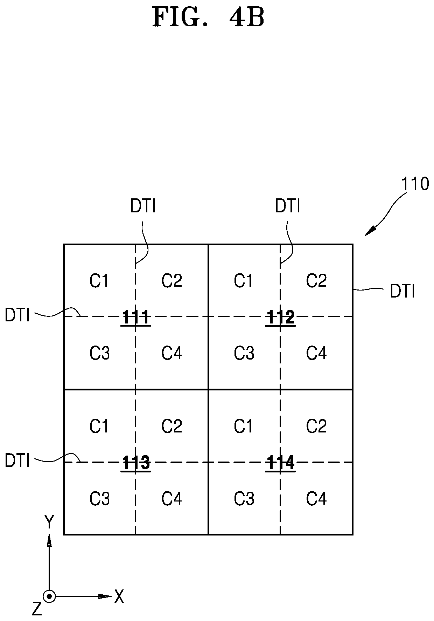

FIG. 4B is a plan view schematically showing another pixel arrangement of the sensor substrate 110 in the pixel array 1100 of FIGS. 3A and 3B. Referring to FIG. 4B, each of the first to fourth pixels 111, 112, 113, and 114 may include a plurality of photosensitive cells that independently sense the incident light, in another example. In this case, each of the first to fourth pixels 111, 112, 113, and 114 may include a plurality of photodiodes. For example, each of the first to fourth pixels 111, 112, 113, and 114 may include first to fourth photosensitive cells C1, C2, C3, and C4. The first to fourth photosensitive cells C1, C2, C3, and C4 may be two-dimensionally disposed in the first direction and the second direction. For example, in each of the first to fourth pixels 111, 112, 113, and 114, the first to fourth photosensitive cells C1, C2, C3, and C4 may be disposed in a 2x2 array.

Also, each of the first to fourth pixels 111, 112, 113, and 114 may include isolations **DTI** that electrically isolate the plurality of photosensitive cells from one another. The isolation **DTI** may have, for example, a deep trench isolation structure. The deep trench may be filled with air or an electrically insulating material. The isolations **DTI** may extend in the first direction and the second direction so as to divide each of the first to fourth pixels 111, 112, 113, and 114 into four. The first to fourth photosensitive cells C1, C2, C3, and C4 in each of the first to fourth pixels 111, 112, 113, and 114 may be isolated from one another by the isolations **DTI.** The isolation **DTI** extending in the first direction and the isolation **DTI** extending in the second direction may cross each other at the center of each of the first to fourth pixels 111, 112, 113, and 114.

Also, the isolations **DTI** may be disposed in the first direction and the second direction between adjacent pixels from among the first to fourth pixels 111, 112, 113, and 114. Therefore, the first to fourth pixels 111, 112, 113, and 114 may be isolated from one another due to the isolations **DTI.** The isolation **DTI** extending in the first direction and the isolation **DTI** extending in the second direction may cross each other at the center of the unit pixel pattern including the first to fourth pixels 111, 112, 113, and 114.

FIG. 4B shows an example in which each of the first to fourth pixels 111, 112, 113, and 114 includes four photosensitive cells, but embodiments are not limited thereto, and four or more independent photosensitive cells may be grouped and two-dimensionally arranged. For example, each of the first to fourth pixels 111, 112, 113, and 114 may include a plurality of independent photosensitive cells that are grouped and arranged in a 3x3 array or 4x4 array. Hereinafter, an example in which each of the first to fourth pixels 111, 112, 113, and 114 includes the photosensitive cells arranged in a 2x2 array will be described for convenience of description.

When each of the first to fourth pixels 111, 112, 113, and 114 includes a plurality of photosensitive cells, an autofocusing signal may be obtained from a difference between output signals from adjacent photosensitive cells. For example, an autofocusing signal in the first direction may be generated from a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, an autofocusing signal in the second direction may be generated from a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

A general RGB image signal may be obtained in two different ways. First, each of the first to fourth photosensitive cells C1, C2, C3, and C4 of the first to fourth pixels 111, 112, 113, and 114 may operate as one independent channel. In this case, the first pixel 111 may include four independent green channels, the second pixel 112 may include four independent blue channels, the third pixel 113 may include four independent red channels, and the fourth pixel 114 may include four independent green channels. One unit pixel pattern may output 16 independent signals. During an image signal processing, a processor may be configured to perform operations, e.g., noise reduction, color correction, etc. by individually using the signals output from the plurality of photosensitive cells and to generate a general RGB image. In an example, the processor may be included in the image sensor 1000, or may be a component included in an electronic apparatus including the image sensor 1000.

According to another example embodiment, a binning mode operation may be performed for increasing sensitivity in a low illuminance environment. The binning mode is an image processing method in which outputs from a plurality of independent photosensitive cells are summed or outputs from a plurality of pixels of the same color are summed. For example, an RGB image may be obtained by summing output signals from the first to fourth photosensitive cells C1, C2, C3, and C4 in the binning mode. For example, a first green image signal may be generated by summing the output signals from the first to fourth photosensitive cells C1, C2, C3, and C4 of the first pixel 111, a blue image signal may be generated by summing the output signals from the first to fourth photosensitive cells C1, C2, C3, and C4 of the second pixel 112, a red image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114. The processor may be configured to perform an image signal process on the summed image signals and to generate the RGB image.

The binning mode may be performed in the software manner using the processor or in the hardware manner using the output circuit 1030 of the image sensor. For example, in the case of the software manner, the output circuit 1030 of the image sensor 100 may individually output the signals from the plurality of photosensitive cells. The processor may be configured to perform a calculation for summing the output signals from the plurality of photosensitive cells in one pixel of one unit pixel pattern, from among the signals from the image sensor 1000, during the image signal processing. In the case of the hardware manner, when the image sensor 1000 receives a binning mode instruction from the processor or another control circuit, the output circuit 1030 may be switched such that output signals from the photosensitive cells in one pixel of one unit pixel pattern are combined and output through one output line. In a general mode, rather than the binning mode, the output circuit 1030 of the image sensor 1000 may be switched so as to individually output the signals from the plurality of photosensitive cells.

Referring back to FIGS. 3A and 3B, the image sensor 1000 may include the spacer layer 120 provided on the sensor substrate 110. The spacer layer 120 is disposed between the sensor substrate 110 and the nano-photonic lens array 130 in order to maintain a constant distance between the sensor substrate 110 and the nano-photonic lens array 130. The spacer layer 120 may include a transparent material for visible ray, for example, a dielectric material having a lower refractive index than that of nano-structures **NP** that are described later and low absorption rate in the visible ray band, e.g., poly methylmethacrylate (PMMA), siloxane-based spin on glass (SOG), silicon oxide (SiO₂), silicon nitride (SiN₄), aluminum oxide (Al₂O₃), etc.

The nano-photonic lens array 130 may be provided on the spacer layer 120. During the process of forming the nano-photonic lens array 130, an etch stop layer may be further provided between the spacer layer 120 and the nano-photonic lens array 130 in order to protect the spacer layer 120. The nano-photonic lens array 130 may include a plurality of first meta-regions 131 corresponding to the plurality of first pixels 111, a plurality of second meta-regions 132 corresponding to the plurality of second pixels 112, a plurality of third meta-regions 133 corresponding to the plurality of third pixels 113, and a plurality of fourth meta-regions 134 corresponding to the plurality of fourth pixels 114. The first meta-region 131 may be arranged to face the first pixel 111 in the third direction (Z-direction), the second meta-region 132 may be arranged to face the second pixel 112 in the third direction, the third meta-region 133 may be arranged to face the third pixel 113 in the third direction, and the fourth meta-region 134 may be arranged to face the fourth pixel 114 in the third direction.

Therefore, the first to fourth meta-regions 131, 132, 133, and 134 may be two-dimensionally disposed in the same manner as that of the first to fourth pixels 111, 112, 113, and 114 described above with reference to FIG. 4A. For example, a plurality of first meta-regions 131 and a plurality of second meta-regions 132 may be alternately arranged in the first direction, and a plurality of third meta-regions 133 and a plurality of fourth meta-regions 134 may be alternately arranged in the first direction in another cross-section at different position in the second direction that is perpendicular to the first direction. Also, one first meta-region 131, one second meta-region 132, one third meta-region 133, and one fourth meta-region 134 arranged in a group of 2x2 array may form one unit meta-pattern.

According to the example embodiment, the nano-photonic lens array 130 may be configured to color-separate incident light. For example, the nano-photonic lens array 130 may separate the light of first wavelength band (e.g., green light), the light of second wavelength band (e.g., blue light), and the light of third wavelength band (e.g., red light) from the incident light and allow the separated light to proceed in different passages. Also, the nano-photonic lens array 130 may be configured to act as a lens condensing light of the first wavelength band, light of the second wavelength band, and light of the third wavelength band that are color-separated onto pixels. For example, the nano-photonic lens array 130 may be configured to condense, in the incident light, light of the first wavelength band onto the first pixel 111 and the fourth pixel 114, light of the second wavelength band onto the second pixel 112, and light of the third wavelength band onto the third pixel 113.

Also, in the nano-photonic lens array 130 according to the example embodiment, color separation and condensation of light may occur independently in each unit meta-pattern. For example, the light incident on one unit meta-pattern is color-separated only in the unit meta-pattern and is condensed only onto the pixels corresponding to the unit meta-pattern, and each unit meta-pattern does not affect the color separation and condensation of light in another adjacent unit meta-pattern. For example, in the light incident on one unit meta-pattern, the light of first wavelength band is condensed only onto the first pixel 111 and the fourth pixel 114 respectively corresponding to the first meta-region 131 and the fourth meta-region 134 of the unit meta-pattern, and is not condensed onto the first and fourth pixels corresponding to another adjacent unit meta-pattern. Similarly, in the light incident on one unit meta-pattern, the light of second wavelength band is condensed only onto the second pixel 112 corresponding to the second meta-region 132 of the unit meta-pattern, and is not condensed onto the second pixel corresponding to another adjacent unit meta-pattern, and the light of third wavelength band is only condensed onto the third pixel 113 corresponding to the third meta-region 133 of the unit meta-pattern and is not condensed onto the third pixel corresponding to another adjacent unit meta-pattern. Therefore, the adjacent unit meta-patterns are optically isolated from each other, and light exchange or energy exchange does not occur between the adjacent unit meta-patterns.

To this end, the nano-photonic lens array 130 may include a plurality of nano-structures NP that are periodically disposed according to a certain rule. Also, the nano-photonic lens array 130 may further include a dielectric layer DL filled among the plurality of nano-structures NP spaced apart from each other. In order for the nano-photonic lens array 130 to perform the above functions, the plurality of nano-structures NP of the nano-photonic lens array 130 may be variously configured. For example, the plurality of nano-structures NP may be disposed such that a phase of light being transmitted through the nano-photonic lens array 140 is changed according to a position on the nano-photonic lens array 130. A phase profile of the transmitted light, which is implemented by the nano-photonic lens array 130, may be determined according to a cross-sectional size (e.g., width or diameter), cross-sectional shape, and a height of each of the nano-structures NP, and intervals, the arrangement period (or pitch), and arrangement type of the plurality of nano-structures NP. Also, the behavior of the light passing through the nano-photonic lens array 130 may be determined according to the phase profile of the transmitted light.

The nano-structures NP may each have a size that is less than a wavelength of visible light. The nano-structures NP may have a size that is less than, for example, the blue wavelength. For example, the cross-sectional width (or diameter) of the nano-structures NP may be less than 400 nm, 300 nm, or 200 nm, and may be greater than about 80 nm. A height of the nano-structures NP may be about 500 nm to about 1500 nm, and may be greater than the cross-sectional width of the nano-structures NP.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (gallium phosphide (GaP), gallium nitride (GaN), gallium arsenide (GaAs) etc.), silicon carbide (SiC), titanium oxide (TiO₂), SiN₃, zinc sulfide (ZnS), zinc selenide (ZnSe), Si₃N₄, and/or a combination thereof. Periphery of the nano-structures NP may be filled with the dielectric layer DL having a relatively lower refractive index as compared with the nano-structures NP and have a relatively low absorbent ratio in the visible ray band. For example, the dielectric layer DL may be filled with PMMA, SOG, SiO₂, Si₃N₄, Al₂O₃, air, etc.

The refractive index of the nano-structures NP may be about 2.0 or greater with respect to light of about a 630 nm wavelength, and the refractive index of the dielectric layer DL may be about 1.0 to about 2.0 or less with respect to light of about a 630 nm wavelength. Also, a difference between the refractive indexes of the nano-structures NP and the refractive index of the dielectric layer DL may be greater than or equal to about 0.5. The nano-structures NP having a difference in a refractive index between the refractive index of the peripheral material may change the phase of light that passes through the nano-structures NP. This is caused by phase delay that occurs due to the shape dimension of the sub-wavelength of the nanostructures NP, and a degree at which the phase is delayed may be determined by a detailed shape dimension and arrangement shape of the nanostructures NP.

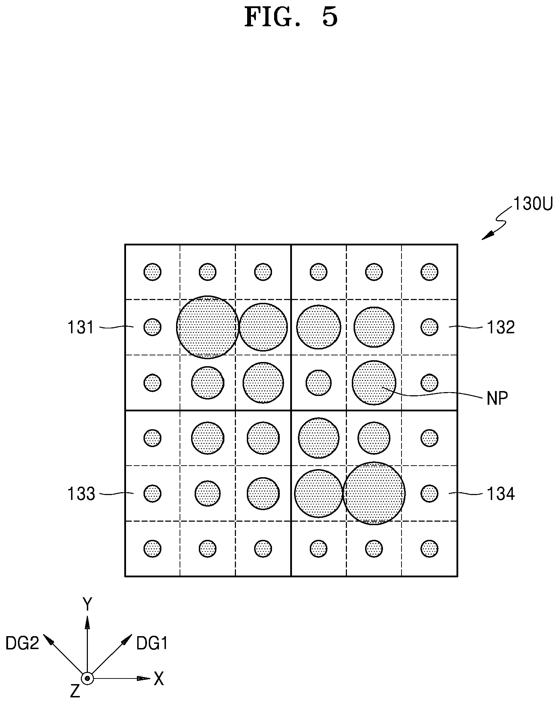

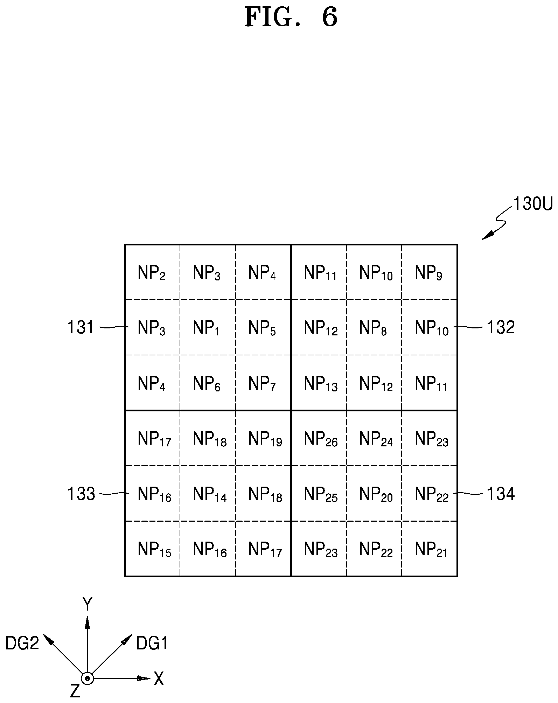

FIG. 5 is a plan view showing an example of an arrangement of a plurality of nano-structures NP in one unit meta-pattern in the nano-photonic lens array 130 of FIGS. 3A and 3B, and FIG. 6 is a diagram showing a plurality of different nano-structures indicated by reference numerals, the nano-structures NP being arranged in the first to fourth meta-regions 131, 132, 133, and 134 of one unit meta-pattern in the nano-photonic lens array 130. In addition, in FIGS. 5 and 6, grids indicated by dashed lines in the first meta-region 131, the second meta-region 132, the third meta-region 133, and the fourth meta-region 134 are provided to clearly indicate the positions of the nano-structures NP, and are not relevant with the actual structures of the first meta-region 131, the second meta-region 132, the third meta-region 133, and the fourth meta-region 134.

Referring to FIG. 5, one unit meta pattern 130U in the nano-photonic lens array 130 may include the first meta-region 131, the second meta-region 132, the third meta-region 133, and the fourth meta-region 134 arranged in the group of 2x2 array. In one unit meta-pattern 130U, the second meta-region 132 and the third meta-region 133 may be arranged in a first diagonal line DG1 direction and the first meta-region 131 and the fourth meta-region 134 may be arranged in a second diagonal line DG2 direction. FIG. 5 shows an example of one unit meta-pattern 130U, but the nano-photonic lens array 130 may include a plurality of unit meta-patterns 130U that are two-dimensionally and periodically arranged in the first direction and the second direction. The plurality of unit meta-patterns 130U may each correspond to one of the plurality of unit pixel patterns of the sensor substrate 110. The pattern period or lattice constant of the plurality of unit meta-patterns 130U in the nano-photonic lens array 130 may be equal to those of the plurality of unit pixel patterns in the sensor substrate 110.

The first meta-region 131, the second meta-region 132, the third meta-region 133, and the fourth meta-region 134 may each include a plurality of nano-structures NP having different cross-sectional areas from one another. In the example of FIG. 5, each of the first meta-region 131, the second meta-region 132, the third meta-region 133, and the fourth meta-region 134 includes nine nano-structures NP that are two-dimensionally arranged in a 3x3 array, but is not limited thereto. For example, each of the first meta-region 131, the second meta-region 132, the third meta-region 133, and the fourth meta-region 134 may include the plurality of nano-structures NP that are two-dimensionally arranged in a 4x4 array, a 5x5 array, or greater.

In the first meta-region 131, the second meta-region 132, the third meta-region 133, and the fourth meta-region, materials, cross-sectional shapes, heights, positions, period, and arrangement types of the plurality of nano-structures NP are the same, but the cross-sectional areas of the nano-structures NP may be selected to be different from one another. For example, in the first meta-region 131, the second meta-region 132, the third meta-region 133, and the fourth meta-region 134, distributions of cross-sectional areas of the plurality of nano-structures NP may be different from one another. FIG. 5 shows an example, in which the plurality of nano-structures NP have circular cross-sections on the plane parallel to the first and second directions, that is, the plurality of nano-structures NP have cylindrical shapes, but embodiments are not limited thereto. On the plane parallel to the first and second directions, the plurality of nano-structures NP may have circular cross-sections, elliptical cross-sections, or polygonal cross-sections such as rectangular cross-sections. Hereinafter, the cross-sectional area of each of the plurality of nano-structures NP may be defined as an area of the cross-section of each of the plurality of nano-structures NP along the plane parallel to the first and second directions.

In each of the first meta-region 131, the second meta-region 132, the third meta-region 133, and the fourth meta-region 134, the distribution of the cross-sectional areas of the plurality of nano-structures NP may be selected in consideration of the above-described phase delay function of the nano-photonic lens array 130. For example, the plurality of nano-structures NP may be arranged such that the color separation and condensation of light may be performed independently in each of the unit meta-patterns 130U without light exchange or energy exchange among the plurality of unit meta-patterns 130U. In particular, the distribution of the cross-sectional areas of the plurality of nano-structures NP or distribution of phase delay in each of the first meta-region 131, the second meta-region 132, the third meta-region 133, and the fourth meta-region 134 may be determined such that the color separation and condensation of light may be performed independently in each of the unit meta-patterns 130U without the light exchange or energy exchange being generated among the plurality of unit meta-patterns 130U.

For example, the first meta-region 131 may be configured to direct, in the incident light, the light of the second wavelength band to the second pixel 112 corresponding to the second meta-region 132 in the +X direction, and to direct, in the incident light, the light of third wavelength band to the third pixel 113 corresponding to the third meta-region 133 in the -Y direction. The first meta-region 131 does not direct the incident light in the -X direction or +Y direction. To this end, from among the plurality of nano-structures NP in the first meta-region 131, light transmitted through the nano-structure NP that is closer to the second meta-region 132 in the same meta-pattern and the nano-structure NP that is closer to the third meta-region 133 in the same unit meta-pattern may have phase delay greater than phase delays of light transmitted through the other nano-structures NP in the same unit meta-pattern.

Referring to FIGS. 5 and 6, the first meta-region 131 may include a first nanostructure NP1, a second nanostructure NP2, a third nanostructure NP3, a fourth nanostructure NP4, a fifth nanostructure NP5, a sixth nanostructure NP6, and a seventh nano-structure NP7. In FIG. 6, the nano-structures indicated by the same reference numerals may have the same cross-sectional areas. The nano-structures indicated by different reference numerals are independent from each other, and may have the cross-sectional areas that are the same as or different from each other according to the design. In the first meta-region 131, phase delays for light transmitted through the first nano-structure NP₁ at a center, and the fifth nano-structure NP₅, the sixth nano-structure NP₆, and the seventh nano-structure NP₇ that are adjacent to the second meta-region 131 and the third meta-region 133 in the same unit meta-pattern may be greater than phase delays of light transmitted through the second nano-structure NP₂, the third nano-structure NP₃, and the fourth nano-structure NP₄ that are adjacent to another unit meta-pattern that is different from the unit meta-pattern including the first meta-region 131.

FIG. 5 shows an example in which the cross-sectional areas of the first nano-structure NP₁, the fifth nano-structure NP₅, the sixth nano-structure NP₆, and the seventh nano-structure NP₇ are greater than those of the second nano-structure NP₂, the third nano-structure NP₃, and the fourth nano-structure NP₄. However, embodiments are not limited thereto. The phase delay is generally represented as a value wrapped by 2 π. For example, the phase delay that is greater than 2 π may be represented as the remaining value of 2 π. For example, 2.5 π may be equal to 0.5 π and 5 π may be equal to π. Therefore, within a range of 0 to 2 π, the phase delay is in proportional to the cross-sectional area of the nano-structure, but the phase delay of the nano-structure having a greater cross-sectional area than that corresponding to 2 π may be wrapped by 2 π and may be less than 2 π. When the cross-sectional areas of the second nano-structure NP₂, the third nano-structure NP₃, and/or the fourth nano-structure NP₄ may be too small to implement the predetermined phase delay and it may be difficult to manufacture the nano-photonic lens array 130, the cross-sectional areas of the second nano-structure NP₂, the third nano-structure NP₃, and/or the fourth nano-structure NP₄ may be increased so as to implement the phase delay that is obtained by adding 2 π to a target phase delay. In this case, the cross-sectional areas of the second nano-structure NP₂, the third nano-structure NP₃, and the fourth nano-structure NP₄ may be greater than the cross-sectional area of at least one of the first nano-structure NP₁, the fifth nano-structure NP₅, the sixth nano-structure NP₆, and the seventh nano-structure NP₇.

Because the first meta-region 131 directs the light of second wavelength band in the +X direction, directs the light of third wavelength band in the -Y direction, and does not direct the light in the -X direction, the distribution of cross-sectional areas or phase delay of the first to seventh nano-structures NP₁ to NP₇ in the first meta-region 131 may not be symmetrical in any direction with respect to the center of the first meta-region 131. For example, the distribution of the cross-sectional areas or the phase delay of the first to seventh nano-structures NP₁ to NP₇ in the first meta-region 131 is asymmetrical in all of the first direction, the second direction, the first diagonal line direction DG1, and the second diagonal line direction DG2 with respect to the center of the first meta-region 131. Therefore, in the first meta region 131, from among a plurality of pairs of two nano-structures facing each other in the second direction based on a horizontal center line passing through the center of the first meta-region 131 in the first direction, at least one pair of nano-structures may have different cross-sectional areas, from among a plurality of pairs of two nano-structures facing each other in the first direction based on a vertical center line passing through the center of the first meta-region 131 in the second direction, at least one pair of nano-structures may have different cross-sectional areas, from among a plurality of pairs of two nano-structures facing each other with respect to the first diagonal line DG1 passing through the center of the first meta-region 131, at least one pair of nano-structures may have different cross-sectional areas, and from among a plurality of pairs of two nano-structures facing each other with respect to the second diagonal line DG2 passing through the center of the first meta-region 131, at least one pair of nano-structures may have different cross-sectional areas.

For example, the third nano-structure NP₃ and the sixth nano-structure NP₆ facing each other in the second direction with respect to the first nano-structure NP₁ may have different cross-sectional areas, and the fourth nano-structure NP₄ and the seventh nano-structure NP₇ facing each other in the second direction with respect to the fifth nano-structure NP₅ may have different cross-sectional areas. Also, the third nano-structure NP₃ and the fifth nano-structure NP₅ facing each other in the first direction with respect to the first nano-structure NP₁ may have different cross-sectional areas, and the fourth nano-structure NP₄ and the seventh nano-structure NP₇ facing each other in the first direction with respect to the sixth nano-structure NP₆ may have different cross-sectional areas. Also, the third nano-structure NP₃ and the fifth nano-structure NPs, the second nano-structure NP₂ and the seventh nano-structure NP₇, and the third nano-structure NP₃ and the sixth nano-structure NP₆ facing each other based on the first diagonal line DG1 may have different cross-sectional areas, and the fifth nano-structure NP₅ and the sixth nano-structure NP₆ facing each other based on the second diagonal line DG2 may have different cross-sectional areas. However, two third nano-structures NP₃ that are adjacent to another unit meta-pattern different from the unit meta-pattern including the first meta-region 131 and face each other based on the second diagonal line DG2 may have the same cross-sectional areas, and two fourth nano-structures NP₄ that are adjacent to another unit meta-pattern different from the unit meta-pattern including the first meta-region 131 and face each other based on the second diagonal line DG2 may have the same cross-sectional areas.

The second meta-region 132 may be configured to direct, from the incident light, the light of first wavelength band to the first pixel 111 corresponding to the first meta-region 131 in the -X direction, direct the light to the fourth pixel 114 corresponding to the fourth meta-region 134 in the -Y direction, and direct the light of third wavelength band to the third pixel 113 corresponding to the third meta-region 133 in the -X direction and -Y direction. The second meta-region 132 does not direct the incident light in the +X direction or +Y direction. To this end, from among the plurality of nano-structures NP in the second meta-region 132, the nano-structure NP that is closer to the first meta-region 131 in the same meta-pattern and the nano-structure NP that is closer to the fourth meta-region 134 in the same unit meta-pattern may be formed to have greater phase delay than those of the other nano-structures NP.

Referring to FIGS. 5 and 6, the second meta-region 132 may include an eighth nano-structure NP₈, a ninth nano-structure NP₉, a tenth nano-structure NP₁₀, an eleventh nano-structure NP₁₁, a twelfth nano-structure NP₁₂, and a thirteenth nano-structure NP₁₃. In the second meta-region 132, the eighth nano-structure NP₈ at the center and the twelfth nano-structure NP₁₂ and the thirteenth nano-structure NP₁₃ that are adjacent to the first meta-region 131 and the fourth meta-region 134 in the same unit meta-pattern may have greater phase delay than those of the ninth nano-structure NP₉, the tenth nano-structure NP₁₀, and the eleventh nano-structure NP₁₁ that are adjacent to another unit meta-pattern different from the unit meta-pattern including the second meta-region 132. FIG. 5 shows an example in which the cross-sectional areas of the eighth nano-structure NP₈, the twelfth nano-structure NP₁₂, and the thirteenth nano-structure NP₁₃ are greater than those of the ninth nano-structure NP₉, the tenth nano-structure NP₁₀, and the eleventh nano-structure NP₁₁. However, as described above, when the cross-sectional areas of the ninth nano-structure NP₉, the tenth nano-structure NP₁₀, and the eleventh nano-structure NP₁₁ are too small for implementing the phase delays and it is difficult to manufacture the nano-photonic lens array 130, the cross-sectional areas of the ninth nano-structure NP₉, the tenth nano-structure NP₁₀, and the eleventh nano-structure NP₁₁ may be greater than the cross-sectional area of at least one of the eighth nano-structure NP₈, the twelfth nano-structure NP₁₂, and the thirteenth nano-structure NP₁₃.

Because the second meta-region 132 directs the light of first wavelength band in the -X direction and -Y direction and does not direct the light in the +X direction and +Y direction, the distribution of the cross-sectional areas or phase delay of the eighth to thirteenth nano-structures NP₈ to NP₁₃ is symmetrical with respect to the first diagonal line DG1 direction and asymmetrical in the other directions. For example, the distribution of cross-sectional areas or phase delays of the eighth to thirteenth nano-structures NP₈ to NP₁₃ in the second meta-region 132 may be asymmetrical in the first direction, the second direction, and the second diagonal line DG2 direction with respect to the center of the second meta-region 132. Therefore, in the second meta region 132, from among a plurality of pairs of two nano-structures facing each other in the second direction based on a horizontal center line passing through the center of the second meta-region 132 in the first direction, at least one pair of nano-structures may have different cross-sectional areas, from among a plurality of pairs of two nano-structures facing each other in the first direction based on a vertical center line passing through the center of the second meta-region 132 in the second direction, at least one pair of nano-structures may have different cross-sectional areas, two nano-structures facing each other with respect to the first diagonal line DG1 passing through the center of the second meta-region 132 may have the same cross-sectional areas, and from among a plurality of pairs of two nano-structures facing each other with respect to the second diagonal line DG2 passing through the center of the second meta-region 132, at least one pair of nano-structures may have different cross-sectional areas.

For example, two tenth nano-structures NP₁₀ facing each other based on the first diagonal line DG1 may have the same cross-sectional areas, two eleventh nano-structures NP₁₁ may have the same cross-sectional areas, and two twelfth nano-structures NP₁₂ may have the cross-sectional areas. The tenth nano-structure NP₁₀ and the twelfth nano-structure NP₁₂, and the ninth nano-structure NP₉ and the thirteenth nano-structure NP₁₃ facing each other based on the second diagonal line DG2 may have different cross-sectional areas. Also, the tenth nano-structure NP₁₀ and the twelfth nano-structure NP₁₂ facing each other in the second direction with respect to the eighth nano-structure NP₈ may have different cross-sectional areas, and the eleventh nano-structure NP₁₁ and the thirteenth nano-structure NP₁₃ facing each other in the second direction with respect to the twelfth nano-structure NP₁₂ may have different cross-sectional areas. Also, the twelfth nano-structure NP₁₂ and the tenth nano-structure NP₁₀ facing each other in the second direction with respect to the eighth nano-structure NP₈ may have different cross-sectional areas, and the thirteenth nano-structure NP₁₃ and the eleventh nano-structure NP₁₁ facing each other in the first direction with respect to the twelfth nano-structure NP₁₂ may have different cross-sectional areas.

The third meta-region 133 may be configured to direct, in the incident light, the light of first wavelength band to the first pixel 111 corresponding to the first meta-region 131 in the +Y direction, direct the light to the fourth pixel 114 corresponding to the fourth meta-region 134 in the +X direction, and direct the light of second wavelength band to the second pixel 112 corresponding to the second meta-region 132 in the +X direction and +Y direction. The third meta-region 133 does not direct the incident light in the -X direction or -Y direction. To this end, from among the plurality of nano-structures NP in the third meta-region 133, the nano-structure NP that is closer to the first meta-region 131 in the same meta-pattern and the nano-structure NP that is closer to the fourth meta-region 134 in the same unit meta-pattern may be formed to implement greater phase delay than those of the other nano-structures NP.

Referring to FIGS. 5 and 6, the third meta-region 133 may include a fourteenth nano-structure NP₁₄, a fifteenth nano-structure NP₁₅, a sixteenth nano-structure NP₁₆, a seventeenth nano-structure NP₁₇, a eighteenth nano-structure NP₁₈, and a nineteenth nano-structure NP₁₉. In the third meta-region 133, the fourteenth nano-structure NP₁₄ at the center and the eighteenth nano-structure NP₁₈ and the nineteenth nano-structure NP₁₉ that are adjacent to the first meta-region 131 and the fourth meta-region 134 in the same unit meta-pattern may have greater phase delay than those of the fifteenth nano-structure NP₁₅, the sixteenth nano-structure NP₁₆, and the seventeenth nano-structure NP₁₇ that are adjacent to another unit meta-pattern different from the unit meta-pattern including the third meta-region 133. FIG. 5 shows an example in which the cross-sectional areas of the fourteenth nano-structure NP₁₄, the eighteenth nano-structure NP₁₈, and the nineteenth nano-structure NP₁₉ are greater than those of the fifteenth nano-structure NP₁₅, the sixteenth nano-structure NP₁₆, and the seventeenth nano-structure NP₁₇. However, as described above, when the cross-sectional areas of the fifteenth nano-structure NP₁₅, the sixteenth nano-structure NP₁₆, and the seventeenth nano-structure NP₁₇ are too small for implementing the phase delays and it is difficult to manufacture the nano-photonic lens array 130, the cross-sectional areas of the fifteenth nano-structure NP₁₅, the sixteenth nano-structure NP₁₆, and the seventeenth nano-structure NP₁₇ may be greater than the cross-sectional area of at least one of the fourteenth nano-structure NP₁₄, the eighteenth nano-structure NP₁₈, and the nineteenth nano-structure NP₁₉.

Because the third meta-region 133 directs the light of first wavelength band in the +X direction and +Y direction and does not direct the light in the -X direction and - Y direction, the distribution of the cross-sectional areas or phase delay of the fourteenth to nineteenth nano-structures NP₁₄ to NP₁₉ in the third meta-region 133 is symmetrical with respect to the first diagonal line DG1 direction and asymmetrical in the other directions. For example, the distribution of cross-sectional areas or phase delays of the fourteenth to nineteenth nano-structures NP₁₄ to NP₁₉ in the third meta-region 133 may be asymmetrical in the first direction, second direction, and second diagonal line DG2 direction with respect to the center of the third meta-region 133. Therefore, in the third meta region 133, from among a plurality of pairs of two nano-structures facing each other in the second direction on the basis of a horizontal center line passing through the center of the third meta-region 133 in the first direction, at least one pair of nano-structures may have different cross-sectional areas, from among a plurality of pairs of two nano-structures facing each other in the first direction on the basis of a vertical center line passing through the center of the third meta-region 133 in the second direction, at least one pair of nano-structures may have different cross-sectional areas, two nano-structures facing each other with respect to the first diagonal line DG1 passing through the center of the third meta-region 133 may have the same cross-sectional areas, and from among a plurality of pairs of two nano-structures facing each other with respect to the second diagonal line DG2 passing through the center of the third meta-region 133, at least one pair of nano-structures may have different cross-sectional areas.

For example, two sixteenth nano-structures NP₁₆ facing each other based on the first diagonal line DG1 may have the same cross-sectional areas, two seventeenth nano-structures NP₁₇ may have the same cross-sectional areas, and two eighteenth nano-structures NP₁₈ may have the cross-sectional areas. The sixteenth nano-structure NP₁₆ and the eighteenth nano-structure NP₁₈, and the fifteenth nano-structure NP₁₅ and the nineteenth nano-structure NP₁₉ facing each other based on the second diagonal line DG2 may have different cross-sectional areas. Also, the sixteenth nano-structure NP₁₆ and the eighteenth nano-structure NP₁₈ facing each other in the second direction with respect to the fourteenth nano-structure NP₁₄ may have different cross-sectional areas, and the seventeenth nano-structure NP₁₇ and the nineteenth nano-structure NP₁₉ facing each other in the second direction with respect to the eighteenth nano-structure NP₁₈ may have different cross-sectional areas. Also, the sixteenth nano-structure NP₁₆ and the eighteenth nano-structure NP₁₈ facing each other in the first direction with respect to the fourteenth nano-structure NP₁₄ may have different cross-sectional areas, and the seventeenth nano-structure NP₁₇ and the nineteenth nano-structure NP₁₉ facing each other in the first direction with respect to the eighteenth nano-structure NP₁₈ may have different cross-sectional areas.

The fourth meta-region 134 may be configured to direct, in the incident light, the light of the second wavelength band to the second pixel 112 corresponding to the second meta-region 132 in the +Y direction, and to direct, in the incident light, the light of third wavelength band to the third pixel 113 corresponding to the third meta-region 133 in the -X direction. The first meta-region 131 does not direct the incident light in the +X direction or -Y direction. To this end, from among the plurality of nano-structures NP in the fourth meta-region 134, the nano-structure NP that is closer to the second meta-region 132 in the same meta-pattern and the nano-structure NP that is closer to the third meta-region 133 in the same unit meta-pattern may be formed to have greater phase delay than those of the other nano-structures NP.

Referring to FIGS. 5 and 6, the fourth meta-region 134 may include twentieth to twenty-sixth nano-structures NP₂₀ to NP₂₆. In the fourth meta-region 134, the twentieth nano-structure NP₂₀ at the center and the twenty-fourth nano-structure NP₂₄, the twenty-fifth nano-structure NP₂₅, and the twenty-sixth nano-structure NP₂₆ that are adjacent to the second meta-region 132 and the third meta-region 133 in the same unit meta-pattern may have greater phase delay than those of the twenty-first nano-structure NP₂₁, the twenty-second nano-structure NP₂₂, and the twenty-third nano-structure NP₂₃ that are adjacent to another unit meta-pattern different from the unit meta-pattern including the fourth meta-region 134. FIG. 5 shows an example in which the twentieth nano-structure NP₂₀, the twenty-fourth nano-structure NP₂₄, the twenty-fifth nano-structure NP₂₅, and the twenty-sixth nano-structure NP₂₆ have greater cross-sectional areas than those of the twenty-first nano-structure NP₂₁, the twenty-second nano-structure NP₂₂, and the twenty-third nano-structure NP₂₃. However, as described above, when the cross-sectional areas of the twenty-first nano-structure NP₂₁, the twenty-second nano-structure NP₂₂, and the twenty-third nano-structure NP₂₃ are too small for implementing the phase delays and it is difficult to manufacture the nano-photonic lens array 130, the cross-sectional areas of the twenty-first nano-structure NP₂₁, the twenty-second nano-structure NP₂₂, and the twenty-third nano-structure NP₂₃ may be greater than the cross-sectional area of at least one of the twentieth nano-structure NP₂₀, the twenty-fourth nano-structure NP₂₄, the twenty-fifth nano-structure NP₂₅, and the twenty-sixth nano-structure NP₂₆.

Because the fourth meta-region 134 directs the light of second wavelength band in the +Y direction, directs the light of third wavelength band in the -X direction, and does not direct the light in the +X direction and -Y direction, the distribution of cross-sectional areas or phase delay of the twentieth to twenty-sixth nano-structures NP₂₀ to NP₂₆ in the fourth meta-region 134 may not be symmetrical in any direction with respect to the center of the fourth meta-region 134. For example, the distribution of the cross-sectional areas or the phase delay of the twentieth to twenty-sixth nano-structures NP₂₀ to NP₂₆ in the fourth meta-region 134 is asymmetrical in all of the first direction, second direction, first diagonal line DG1 direction, and second diagonal line DG2 direction with respect to the center of the fourth meta-region 134. Therefore, in the fourth meta region 134, from among a plurality of pairs of two nano-structures facing each other in the second direction on the basis of a horizontal center line passing through the center of the fourth meta region 134 in the first direction, at least one pair of nano-structures may have different cross-sectional areas, from among a plurality of pairs of two nano-structures facing each other in the first direction on the basis of a vertical center line passing through the center of the fourth meta region 134 in the second direction, at least one pair of nano-structures may have different cross-sectional areas, from among a plurality of pairs of two nano-structures facing each other with respect to the first diagonal line DG1 passing through the center of the fourth meta region 134, at least one pair of nano-structures may have different cross-sectional areas, and from among a plurality of pairs of two nano-structures facing each other with respect to the second diagonal line DG2 passing through the center of the fourth meta region 134, at least one pair of nano-structures may have different cross-sectional areas.

For example, the twenty-second nano-structure NP₂₂ and the twenty-fourth nano-structure NP₂₄ facing each other in the second direction with respect to the twentieth nano-structure NP₂₀ may have different cross-sectional areas, and the twenty-third nano-structure NP₂₃ and the twenty-sixth nano-structure NP₂₆ facing each other in the second direction with respect to the twenty-fifth nano-structure NP₂₅ may have different cross-sectional areas. The twenty-second nano-structure NP₂₂ and the twenty-fifth nano-structure NP₂₅ facing each other in the first direction with respect to the twentieth nano-structure NP₂₀ may have different cross-sectional areas, and the twenty-third nano-structure NP₂₃ and the twenty-sixth nano-structure NP₂₆ facing each other in the first direction with respect to the twenty-fourth nano-structure NP₂₄ may have different cross-sectional areas. Also, the twenty-second nano-structure NP₂₂ and the twenty-fourth nano-structure NP₂₄, the twenty-first nano-structure NP₂₁ and the twenty-sixth nano-structure NP₂₆, and the twenty-second nano-structure NP₂₂ and the twenty-fifth nano-structure NP₂₅ facing each other based on the first diagonal line DG1 may have different cross-sectional areas, and the twenty-fourth nano-structure NP₂₄ and the twenty-fifth nano-structure NP₂₅ facing each other based on the second diagonal line DG2 may have different cross-sectional areas. However, two twenty-second nano-structures NP₂₂ that are adjacent to another unit meta-pattern different from the unit meta-pattern including the fourth meta-region 134 and face each other based on the second diagonal line DG2 may have the same cross-sectional areas, and two twenty-third nano-structures NP₂₃ that are adjacent to another unit meta-pattern different from the unit meta-pattern including the fourth meta-region 134 and face each other based on the second diagonal line DG2 may have the same cross-sectional areas.

In one unit meta-pattern 130U, the nano-structures NP arranged at the center portion of the unit meta-pattern 130U may be formed to implement greater phase delays as compared with the nano-structures NP arranged at the edges (a peripheral portion) of the unit meta-pattern 130U. In particular, the nano-structures NP that are directly adjacent to another unit meta-pattern 130U may be formed to implement the smallest phase delays as compared with the other nano-structures NP.

In addition, the first meta-region 131 and the fourth meta-region 134 may be asymmetrical with each other with respect to the first diagonal line DG1 passing through the center of the unit meta-pattern 130U. For example, from among the plurality of pairs of nano-structures in the first meta-region 131 and the fourth meta-region 134 facing each other with respect to the first diagonal line DG1 passing through the center of the unit meta-pattern 130U, at least one pair of nano-structures may have different cross-sectional areas. In the example of FIG. 5, the fifth nano-structure NP₅ of the first meta-region 131 and the twenty-fourth nano-structure NP₂₄ of the fourth meta-region 134 facing each other based on the first diagonal line DG1 may have different cross-sectional areas, and the sixth nano-structure NP₆ of the first meta-region 131 and the twenty-fifth nano-structure NP₂₅ of the fourth meta-region 134 may have different cross-sectional areas. The other nano-structures in the first metal region 131 and the other nano-structures in the fourth meta-region 134 facing each other with respect to the first diagonal line DG1 passing through the center of the unit meta-pattern 130U may have the same cross-sectional areas. Throughout the entire unit meta-pattern 130U, the distribution of cross-sectional areas of the nano-structures arranged in the unit meta-pattern 130U may be asymmetrical in all of the first direction, second direction, first diagonal line DG1 direction, and second diagonal line DG2 direction with respect to the center of the unit meta-pattern 130U.

Also, the first meta-region 131 and the fourth meta-region 134 may be in a 180°-angle rotational symmetric relationship with respect to the center of the unit meta-pattern 130U. In particular, the distribution of cross-sectional areas or phase delays of the plurality of nano-structures NP in the first meta-region 131 and the distribution of cross-sectional areas or phase delays of the plurality of nano-structures NP in the fourth meta-region 134 may be in the 180°-angle rotational symmetric relationship with respect to the center of the unit meta-pattern 130U. For example, when the first meta-region 131 or the fourth meta-region 134 is rotated by 180°-angle about a point where an apex of the first meta-region 131 and an apex of the fourth meta-region 134 meet each other, the shapes and cross-sectional areas of the nano-structures in the first meta-region 131 and the shapes of the nano-structures in the fourth meta-region 134 may be the same as each other. In this case, in the example of FIG. 5, the fifth nano-structure NP₅ of the first meta-region 131 and the twenty-fifth nano-structure NP₂₅ of the fourth meta-region 134 may have the same cross-sectional areas, and the sixth nano-structure NP₆ of the first meta-region 131 and the twenty-fourth nano-structure NP₂₄ of the fourth meta-region 134 may have the same cross-sectional areas.

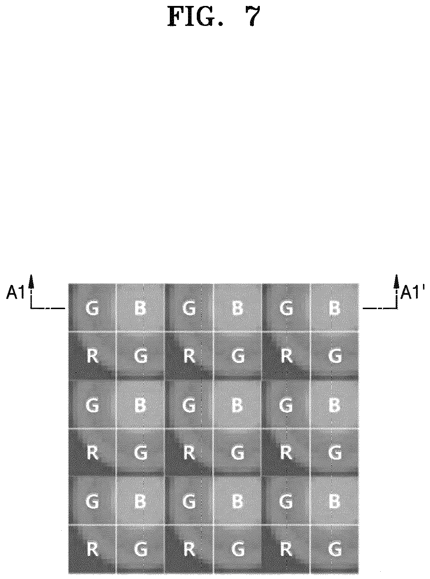

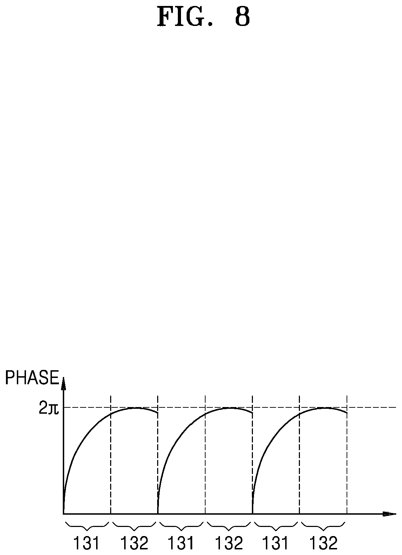

FIG. 7 is a distribution diagram showing a phase profile of blue light that has passed through the nano-photonic lens array 130, and FIG. 8 is a graph showing an example of a phase profile of blue light on a cross-section taken alone line A1-A1' of FIG. 7. Referring to FIGS. 7 and 8, the blue light that has passed through the color separating lens array 130 may have a phase profile that is the largest at the center of the second meta-region 132 and is reduced away from the center of the second meta-region 132. For example, at a position immediately after passing through the nano-photonic lens array 130, that is, on the lower surface of the nano-photonic lens array 130, the phase of the blue light is largest at the center of the second meta-region 132 and may reduce into a concentric circle away from the center of the second meta-region 132. Also, the phase profile of the blue light is continuous in one unit meta-pattern, but may be discontinuous at a boundary between two adjacent meta-patterns.

Then, in one unit meta-pattern, in the incident light incident on the second meta-region 132 and the incident light incident on the first meta-region 131, the third meta-region 133, and the fourth meta-region around the second meta-region 132, the blue light may be condensed onto the second pixel 112 corresponding to the second meta-region 132. For example, the blue light incident on one unit meta-pattern may be condensed onto the second pixel 112 corresponding to the second meta-region 132 of the unit meta-pattern. However, because the phase profile of the blue light is discontinuous at the boundary between the two adjacent meta-patterns, the blue light incident on one unit meta-pattern may not be condensed onto the second pixel 112 corresponding to another unit meta-pattern that is adjacent to the above unit meta-pattern.

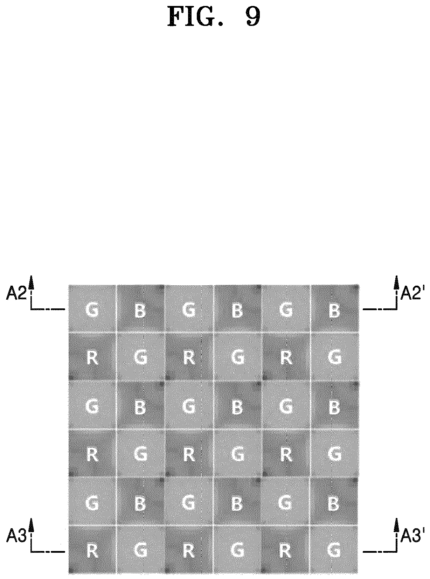

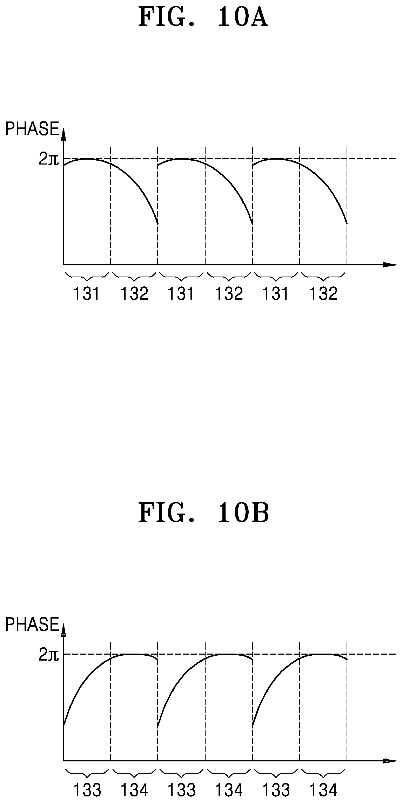

FIG. 9 is a distribution diagram showing an example of a phase profile of green light that has passed through the nano-photonic lens array 130, FIG. 10A is a graph showing an example of a phase profile of green light on a cross-section taken along line A2-A2' of FIG. 9, and FIG. 10B is a graph showing an example of a phase profile of green light on a cross-section taken along line A3-A3' of FIG. 9. Referring to FIGS. 9, 10A, and 10B, the green light that has passed through the nano-photonic lens array 130 may have a phase profile that is largest at the center of the first meta-region 131 and the center of the fourth meta-region 134 and reduces away from the centers of the first and fourth meta-regions 131 and 134. For example, at a position immediately after passing through the nano-photonic lens array 130, that is, on the lower surface of the nano-photonic lens array 130, the phase of the green light is largest at the center of the first meta-region 131 and the center of the fourth meta-region 134 and may reduce into a concentric circle away from the center of the first meta-region 131 and the center of the fourth meta-region 134. Also, the phase profile of the green light is continuous in one unit meta-pattern, but may be discontinuous at a boundary between two adjacent meta-patterns.

Then, the green light incident on one unit meta-pattern may be condensed onto the first pixel 111 corresponding to the first meta-region 131 and the fourth pixel 114 corresponding to the fourth meta-region 134 of the unit meta-pattern. However, because the phase profile of the green light is discontinuous at the boundary between the two adjacent meta-patterns, the green light incident on one unit meta-pattern may not be condensed onto the first pixel 111 and the fourth pixel 114 corresponding to another unit meta-pattern that is adjacent to the above unit meta-pattern.

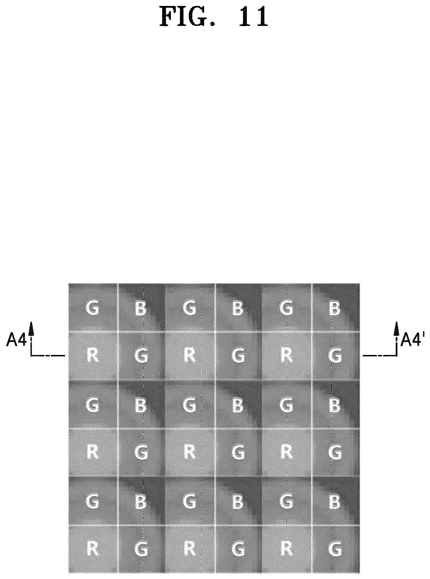

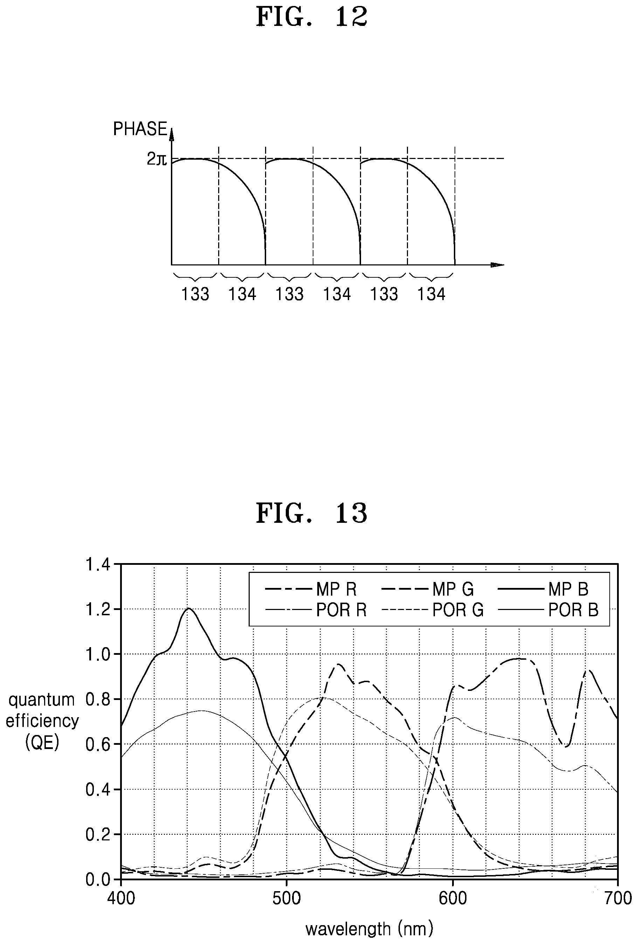

FIG. 11 is a distribution diagram showing a phase profile of red light that has passed through the nano-photonic lens array 130, and FIG. 12 is a graph showing an example of a phase profile of red light on a cross-section taken alone line A4-A4' of FIG. 11. Referring to FIGS. 11 and 12, the red light that has passed through the color separating lens array 130 may have a phase profile that is largest at the center of the third meta-region 133 and reduces away from the center of the third meta-region 133. For example, at a position immediately after passing through the nano-photonic lens array 130, that is, on the lower surface of the nano-photonic lens array 130, the phase of the red light is largest at the center of the third meta-region 133 and may reduce into a concentric circle away from the center of the third meta-region 133. Also, the phase profile of the red light is continuous in one unit meta-pattern, but may be discontinuous at a boundary between two adjacent meta-patterns.

Then, the red light incident on one unit meta-pattern may be condensed onto the third pixel 113 corresponding to the third meta-region 133 of the unit meta-pattern. However, because the phase profile of the red light is discontinuous at the boundary between the two adjacent meta-patterns, the red light incident on one unit meta-pattern may not be condensed onto the third pixel 113 corresponding to another unit meta-pattern that is adjacent to the above unit meta-pattern.

FIG. 13 is a graph showing a light utilization efficiency of the image sensor 1000 according to an embodiment versus a light utilization efficiency of an image sensor according to a related example. In FIG. 13, graphs represented as 'POR R', 'POR G', and 'POR B' indicate quantum efficiencies with respect to red light, green light, and blue light in an image sensor according to the related example, in which a color filter and a micro-lens are arranged on a sensor substrate. In the related example, it is assumed that one micro-lens is arranged with respect to one unit pixel pattern of the sensor substrate. Also, in FIG. 13, graphs represented as 'MP R', 'MP G', and 'MP B' indicate quantum efficiencies with respect to the red light, green light, and blue light in the image sensor 1000 according to the example embodiment. Referring to FIG. 13, the nano-photonic lens array 130 color-separates the incident light and condenses the color-separated light onto each pixel without absorbing or reflecting the incident light, and thus, the incident light 1000 according to the example embodiment may have improved light utilization efficiency with respect to the blue light, green light, and red light as compared with the image sensor according to the related example. Therefore, a size of one pixel or size of independent photosensitive cells in the pixel of the image sensor 1000 may be reduced, and thus, the image sensor 1000 having higher resolution may be provided.

Also, according to the example embodiment, there is no energy exchange or light exchange between adjacent unit meta-patterns 130U in the nano-photonic lens array 130, and thus, degradation in a spatial resolution may be reduced while improving the light utilization efficiency. For example, the color-separated and condensed light in one unit meta-pattern only include spatial information of the light incident on the unit meta-pattern, and does not include spatial information of the light incident on another adjacent unit meta-pattern. Therefore, mixture of the light having different spatial information is not incident on one pixel, and thus, each pixel may output a signal having its own spatial information.

Also, the outputs from the pixels in the unit pixel pattern corresponding to one unit meta-pattern of the nano-photonic lens array 130 may have the same spatial information regardless of the color. For example, green light signals output from the first pixel 111 and the fourth pixel 114, a blue light signal output from the second pixel 112, and a red light signal output from the third pixel 113 in the unit pixel pattern corresponding to one unit meta-pattern may have the same spatial information. In this case, all of the green light signals, blue light signals, and red light signals output from the entire pixels in the image sensor 1000 or the pixel array 1100 may have the spatial information on the entire area of the image sensor or the pixel array 1100 without a gap. Therefore, an operation such as demosaicing or color filter array interpolation for filling empty spatial information between the pixels of the same color in the image sensor having a Bayer pattern structure according to the related art may be omitted in the image processing for generating image by using the signals output from the image sensor 1000 according to the example embodiment. Accordingly, an operation amount and power consumption of an image signal processor of an apparatus including the image sensor or a processor in the image sensor 1000 may be reduced.

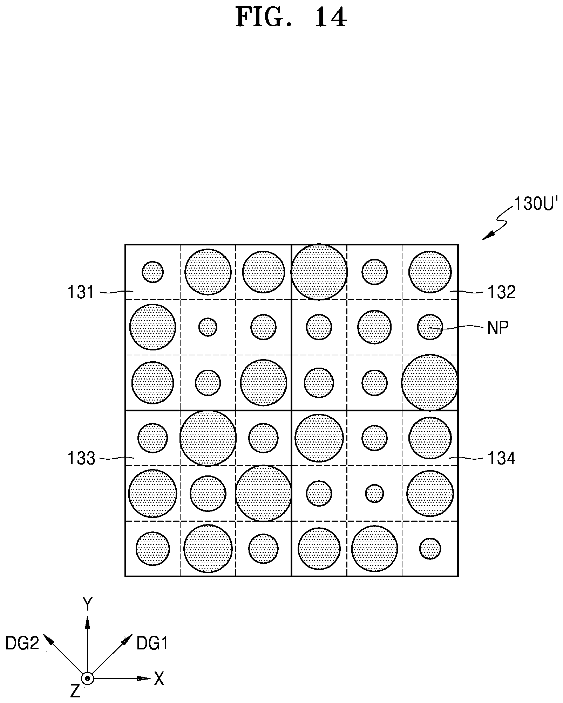

FIG. 14 is a plan view showing an example of an arrangement of a plurality of nano-structures NP in one meta-pattern of the nano-photonic lens array 130 according to another example embodiment. The cross-sectional areas of the plurality of nano-structures NP in a unit meta-pattern 130U' of FIG. 14 may be different from those of the plurality of nano-structures NP in the unit meta-pattern 130U of FIG. 5. However, the nano-photonic lens array 130 including the unit meta-pattern 130U' of FIG. 14 may also implement the phase profile as shown in FIGS. 7 to 12. As described above, because the phase delay may be represented as a value wrapped by 2 π, various other arrangement types or various other cross-sectional area distribution of the nano-structures NP, which may implement the same phase profile, may be designed in consideration of the condition of manufacturing the nano-structures NP, etc.

Even when the arrangement type or cross-sectional area distribution of the nano-structures NP is changed, the conditions described above with reference to FIGS. 5 and 6 may be satisfied. For example, in the first meta-region 131 and the fourth meta-region 134, the cross-sectional area distribution or phase delay distribution of the plurality of nano-structures NP may be asymmetrical in the first direction, the second direction, the first diagonal line DG1 direction, and the second diagonal line DG2 direction with respect to the center of each meta-region. Also, the first meta-region 131 and the fourth meta-region 134 may be in a 180°-angle rotational symmetric relationship with respect to the center of the unit meta-pattern 130U'. In the second meta-region 132 and the fourth meta-region 134, the cross-sectional area distribution or the phase delay distribution of the plurality of nano-structures NP may be symmetrical with respect to the first diagonal line DG1 direction with respect to the center of each meta-region, and may be asymmetrical in the first direction, the second direction, and the second diagonal line DG2 direction.

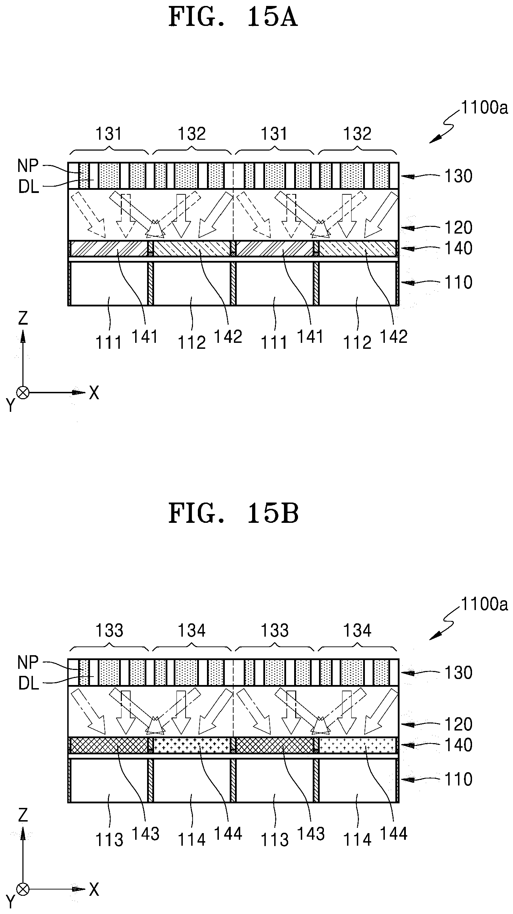

FIGS. 15A and 15B are cross-sectional views schematically showing a structure of a pixel array in the image sensor 1000 according to another example embodiment. Referring to FIGS. 15A and 15B, a pixel array 1100a according to another example embodiment may further include a color filter array 140 provided between the sensor substrate 110 and the spacer layer 120. The color filter array 140 may include a plurality of color filters each transmitting light of a certain wavelength band and absorbing light of different wavelength bands. For example, the color filter array 140 may include a first color filter 141 and a fourth color filter 144 that transmit light of a first wavelength band and absorb light of another wavelength band, a second color filter 142 that transmits light of a second wavelength band that is different from the first wavelength band and absorbs light of another wavelength band, and a third color filter 143 that transmits light of a third wavelength band that is different from the first and second wavelength bands and absorbs light of another wavelength band.

The first color filter 141 may be arranged to face the first pixel 111 in a third direction, the second color filter 142 may be arranged to face the second pixel 112 in the third direction, the third color filter 143 may be arranged to face the third pixel 113 in the third direction, and the fourth color filter 144 may be arranged to face the fourth pixel 114 in the third direction. Accordingly, the first pixel 111 may sense the light of the first wavelength band that passed through the first color filter 141 corresponding thereto. The second pixel 112 senses the light of the second wavelength band that passed through the corresponding second color filter 142, and the third pixel 113 senses the light of the third wavelength band that passed through the corresponding third color filter 143. The fourth pixel 114 may sense the light of the first wavelength band that has passed through the fourth color filter 144 corresponding thereto. In an example, the first color filter 141 and the fourth color filter 144 may be green color filters transmitting the green light, the second color filter 142 may be a blue color filter transmitting the blue light, and the third color filter 143 may be a red color filter transmitting the red light.

Because the incident light is color-separated by the nano-photonic lens array 130 to a certain degree, the absorption loss in the color filter array 140 may be relatively low even when the color filter array 140 is used. A color purity may be improved because the nano-photonic lens array 130 and the color filter array 140 are used together. The color filter array 140 may be omitted provided that the sufficient color separation may occur due to the nano-photonic lens array 130.

The first to fourth color filters 141, 142, 143, and 144 of the color filter array 140 may be formed of an organic polymer material. For example, the first to fourth color filters 141, 142, 143, and 144 may include a coloring agent, binder resin, polymer photoresist, etc. In this case, the spacer layer 120 may act as a planarization layer providing a flat surface for forming the nano-photonic lens array 130 on the color filter array 140. Also, the spacer layer 120 may include an organic polymer material that is suitable for being stacked on the color filter array 140 that is formed of an organic material and may easily form a flat surface. The organic polymer material forming the spacer layer 120 may be transparent with respect to visible light. For example, the spacer layer 120 may include at least one organic polymer material from an epoxy resin, polyimide, polycarbonate, polyacrylate, and polymethyl methacrylate (PMMA). The spacer layer 120 may be formed on the color filter array 140 by, for example, a spin coating method, and may have a flat upper surface through a thermal treatment.

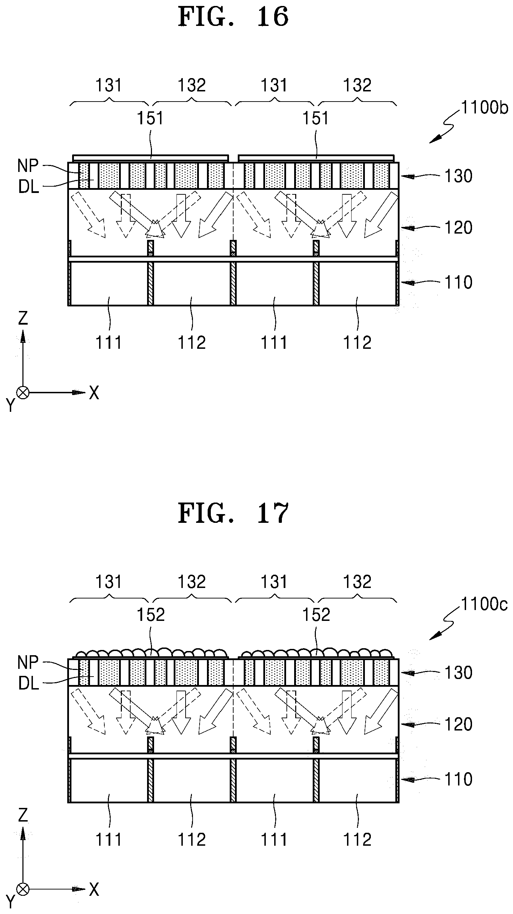

FIG. 16 is a cross-sectional view schematically showing a structure of a pixel array in the image sensor 1000 according to another example embodiment. Referring to FIG. 16, a pixel array 1100b may further include a plurality of isolation patterns 151 provided on the upper surface of the nano-photonic lens array 130 in order to improve the optical isolation between the plurality of unit meta-patterns. Each of the plurality of isolation patterns 151 may be disposed on the corresponding unit meta-pattern from among the plurality of unit meta-patterns of the nano-photonic lens array 130. For example, each of the plurality of isolation patterns 151 may be provided to cover the first to fourth meta-regions 131, 132, 133, and 134 of the corresponding meta-pattern. FIG. 16 shows that the isolation pattern 151 covers the first and second meta regions 131 and 132, but the isolation pattern 151 may further cover the third and fourth meta-regions 133 and 134 on a cross-section at different position from FIG. 16 in the second direction. Also, each of the plurality of isolation patterns 151 may be isolated from adjacent isolation patterns 151. The isolation pattern 151 may have a flat upper surface. The isolation pattern 151 may include a material that has a lower refractive index than that of the nano-structures NP and is transparent with respect to the visible ray. For example, the isolation pattern 151 may include PMMA, SOG, SiO₂, Si₃N₄, Al₂O₃, etc. A thickness of each isolation pattern 151 in the third direction may be determined considering the pixel size, etc. in the image sensor 1000 such that the sufficient optical separation may occur between the plurality of unit meta-patterns of the nano-photonic lens array 130.

FIG. 17 is a cross-sectional view schematically showing a structure of a pixel array in the image sensor 1000 according to another example embodiment. Referring to FIG. 17, a pixel array 1100c may further include a plurality of isolation patterns 152 provided on the upper surface of the nano-photonic lens array 130 in order to improve the optical isolation between the plurality of unit meta-patterns, according to another example embodiment. The arrangement and structure of the isolation patterns 152 of FIG. 17 may be the same as those of the isolation patterns 151 of FIG. 16. The isolation patterns 152 of FIG. 17 may be different from the isolation patterns 151 of FIG. 16, in that the isolation patterns 152 may each have an upper surface that is irregularly uneven. For example, the isolation pattern 152 may be a diffusion pattern that scatters and diffuses the light incident on the corresponding unit meta-pattern. Then, the identity of spatial information among the signals output from the first to fourth pixels 111, 112, 113, and 114 corresponding to each unit meta-pattern may be improved.

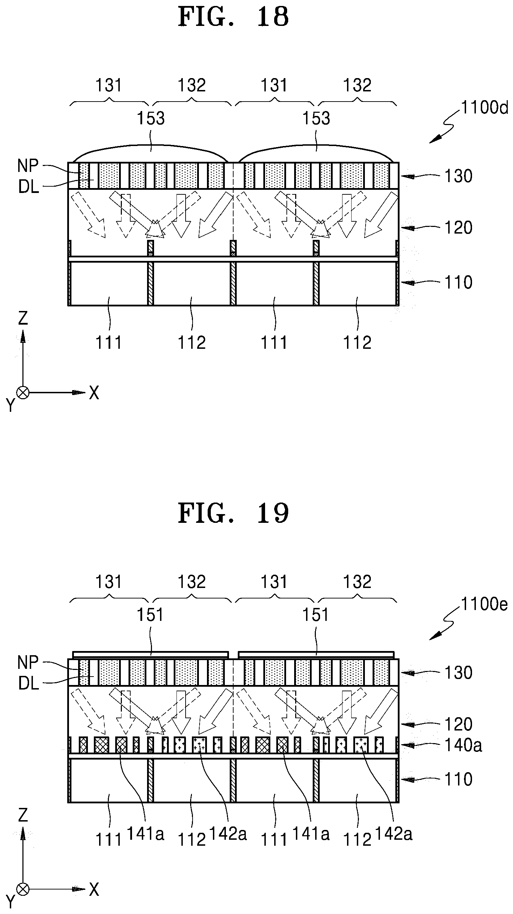

FIG. 18 is a cross-sectional view schematically showing a structure of a pixel array in the image sensor 1000 according to another example embodiment. Referring to FIG. 18, a pixel array 1100d may further include a plurality of isolation patterns 153 provided on the upper surface of the nano-photonic lens array 130 in order to improve the optical isolation between the plurality of unit meta-patterns, according to another example embodiment. The arrangement of the isolation patterns 153 of FIG. 18 may be the same as the arrangement of the isolation patterns 151 of FIG. 16. The isolation patterns 153 of FIG. 18 may have a convex upper surface for condensing the incident light onto a corresponding unit pixel pattern from among the plurality of unit pixel patterns of the sensor substrate 110. For example, the isolation pattern 153 may be a micro-lens condensing the incident light onto the corresponding unit meta-pattern.

FIG. 19 is a cross-sectional view schematically showing a structure of a pixel array in an image sensor 1000 according to another example embodiment. Referring to FIG. 19, a pixel array 1000e may include an inorganic color filter array 140a, instead of the color filter array 140 of FIGS. 15A and 15B. The inorganic color filter array 140a may include a plurality of inorganic color filters having an inorganic lattice structure. FIG. 19 only shows a first inorganic color filter 141a corresponding to the first pixel 111 and a second inorganic color filter 142a corresponding to the second pixel 112, but the inorganic color filter array 140a may further include a third inorganic color filter corresponding to the third pixel 113 and a fourth inorganic color filter corresponding to the fourth pixel 114 on a cross-section of a different position in the second direction from FIG. 19. When the pixel array 1100e includes the inorganic color filter array 140a, the spacer layer 120 may include a general transparent inorganic material such as SOG, SiO₂, Si₃N₄, Al₂O₃, etc.

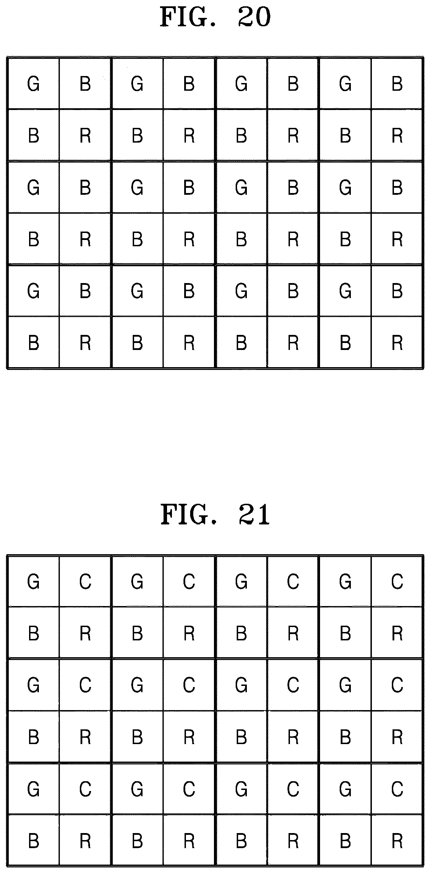

In addition, because the outputs from the first to fourth pixels 111, 112, 113, and 114 in one unit pixel pattern have the same spatial information, the image sensor 1000 according to the example embodiment does not need to have pixel arrangement in the Bayer pattern structure. In the pixel arrangement of the Bayer pattern structure according to the related art, lost spatial information is reconstructed by using the green pixels having the largest number. However, there may be no substantial loss in the spatial information in the image sensor 1000 according to the example embodiment. Therefore, the pixels may be arranged in various types according to usage and characteristics of the image sensor 1000 without having a limitation in the pixel arrangement. For example, FIGS. 20 to 22 are diagrams showing examples of various pixel arrangements in a pixel array of the image sensor 1000 according to another example embodiment.

Referring to FIG. 20, one unit pixel pattern in the pixel array may include two blue pixels B, one green pixel G, and one red pixel R. Two blue pixels B are arranged in a first diagonal line direction, and the green pixel G and the red pixel R may be arranged in a second diagonal line direction. The pixel array may include a plurality of unit pixel patterns each having the above structure.

In this case, two meta-regions of the nano-photonic lens array 130, which correspond to the blue pixels B, may comply with the rules about the cross-sectional area distribution or the phase delay distribution of the nano-structures NP in the first and fourth meta-regions 131 and 134 described above with reference to FIGS. 5 and 6. For example, the cross-sectional area distribution of the nano-structures in two meta-regions of the nano-photonic lens array 130, which correspond to the blue pixels B, may be asymmetrical in all of the first direction, the second direction, the first diagonal line direction, and the second diagonal line direction. Also, two meta-regions of the nano-photonic lens array 130, which correspond to the blue pixels B, may be in a 180°-angle rotational symmetric relationship with respect to the center of the unit meta-pattern.

The meta-regions of the nano-photonic lens array 130, which correspond to the green pixel G and the red pixel R, may comply with the rules about the cross-sectional area distribution or the phase delay distribution of the nano-structures NP in the second and third meta-regions 132 and 133 described above with reference to FIGS. 5 and 6. For example, in the meta-regions of the nano-photonic lens array 130, which correspond to the green pixel G and the red pixel R, the cross-sectional area distribution or the phase delay distribution of the nano-structures may be symmetrical with respect to the first diagonal line direction and asymmetrical in the first direction, the second direction, and the second diagonal line direction with respect to the center of each meta-region.

Referring to FIG. 21, one unit pixel pattern of the pixel array may include one green pixel G, one cyan pixel C, one blue pixel B, and one red pixel R. In this case, in all of the meta-regions in the nano-photonic lens array 130, which respectively correspond to the green pixel G, the cyan pixel C, the blue pixel B, and the red pixel R, the cross-sectional area distribution of the nano-structures may be asymmetrical with respect to the first direction, the second direction, the first diagonal line direction, and the second diagonal line direction.

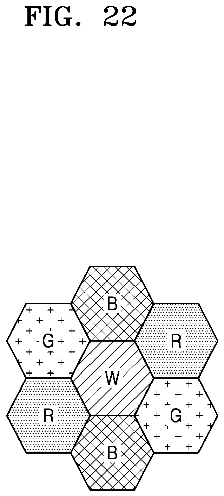

Referring to FIG. 22, the pixel array may include a plurality of pixels each having a hexagonal shape. For example, one unit pixel pattern in the pixel array may include seven pixels each having a hexagonal shape. A white pixel W may be arranged at the center of the unit pixel pattern, and two green pixels G, two blue pixels **B,** and two red pixels R may be arranged respectively to come into contact with six sides of the white pixel W. For example, the pixels of the same color may be arranged on two sides facing each other, from among six sides of the white pixel W. For example, two green pixels G may be arranged on two sides facing each other of the white pixel W, two blue pixels B may be arranged on two different sides facing each other of the white pixel W, and two red pixels R may be arranged on the remaining two sides facing each other of the white pixel W.

As described above, the color-separated and condensed light in one unit meta-pattern may only include spatial information of the light incident on the unit meta-pattern, and may not include spatial information of the light incident on another adjacent unit meta-pattern. Also, color signals output from the pixels in one unit pixel pattern, e.g., one Bayer pattern, may represent the color of the entire unit pixel pattern. For example, the red light signal output from the red pixel in one unit pixel pattern may represent the entire red light in the incident light incident on the unit pixel pattern. Similarly, the blue light signal from the blue pixel may represent the entire blue light in the incident light incident on the unit pixel pattern. An average of green light signals output respectively from two green pixels in one unit pixel pattern may represent the entire green light in the incident light incident on the unit pixel pattern.

Therefore, even when there is a position difference between the red pixels, the green pixels, and the blue pixels, the red light signal, the green light signal, and the blue light signal may have the same spatial information. Because the spatial information among the red light signal, the green light signal, and the blue light signal output from one unit pixel pattern is the same, higher-quality color images may be obtained without performing the demosaicing process during the image processing using the output from the pixel array 1100. Therefore, the image processing may be more simplified by using the image sensor 1000 according to the example embodiment.

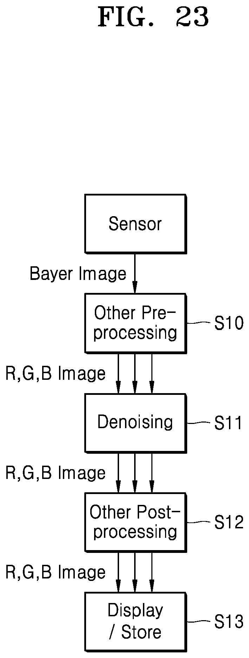

FIG. 23 is a flowchart schematically illustrating image processing according to an example embodiment. Referring to FIG. 23, in operation S10, a pre-process may be performed on an image signal output from the pixel array 1100, e.g., image signal based on the Bayer pattern. For example, in pre-process operation S10, a black level compensation that compensates for differences in a black level due to a dark current, a defective pixel correction that compensates for signal loss due to defective pixels such as dead pixels, a white balance adjustment, etc. may be performed. After that, digitalized red image data, green image data, and blue image data may be generated. According to another example embodiment, digital image data may be generated according to an image format required by another external device rather than the image sensor 1000 (e.g., digital camera, smartphone, closed circuit television (CCTV)).

When finishing the pre-process operation (S10), noise removal from the digital image data may be performed in operation S11. In noise removal operation (S11), an original image may be estimated based on the digital image data after the pre-process and the noise components included in the digital data may be removed.

After removing the noises, a post-process for improving quality of a final image may be performed in operation S12. For example, in the post-process operation (S12), a brightness adjustment for correcting too bright or dark regions in the image, e.g., a deblurring for removing blurred region in the image and a high dynamic range (HDR), and a color correction for adjusting colors according to sensor characteristics of a camera to be suitable for characteristics of human eyes, may be performed.

After generating a final image, the final image may be displayed on a display panel, etc. or may be stored in a recording medium in operation S13.

The pre-process operation (S10) of FIG. 23 may be performed in a processor in the image sensor 1000. According to another example embodiment, an additional image processor included in another device out of the image sensor 1000 may receive RAW image data from the image sensor 1000 and may be configured to perform the pre-process operation (S10). Also, the noise removal operation (S11) and the post-process operation (S12) may be performed by an additional image processor included in another device out of the image sensor 1000.

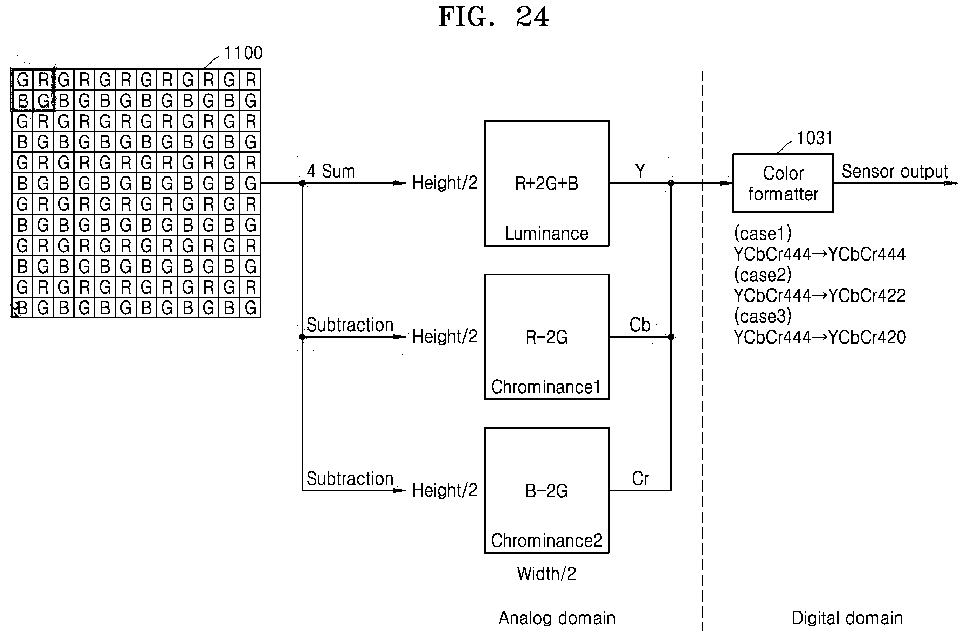

FIG. 24 is a diagram showing an example of image processing by the image sensor 1000 in pre-process operation (S10) of FIG. 23. Referring to FIG. 24, an analog binning may be performed on each unit pixel pattern in the pixel array 1100 for generating image data of various formats. In FIG. 24, one Bayer pattern that is a unit pixel pattern in the pixel array 1100 having the Bayer pattern structure is indicated in a bold square. In one unit pixel pattern, output from the red pixel (e.g., third pixel 113), output from two green pixels (e.g., first pixel 111 and fourth pixel 114), and output from the blue pixel (e.g., second pixel 112) are summed to generate one luminance signal Y. Also, in one unit pixel pattern, the outputs from the two green pixels are subtracted from the output from the red pixel to generate a first color signal Cb, and the outputs from the two green pixels are subtracted from the output from the blue pixel to generate a second color signal Cr.

In FIG. 24, height denotes a height of one unit pixel pattern and width denotes a width of one unit pixel pattern. Also, in FIG. 24, Height/2 and Width/2 respectively denote a height and a width of each pixel. According to the example embodiment, a demosaicing process is not performed on the output from the red pixel, the output from the two green pixels, and the output from the blue pixel, and the luminance signal Y, the first color signal Cb, and the second color signal Cr may be directly generated from the outputs from the pixels. In this case, one luminance signal Y, one first color signal Cb, and one second color signal Cr may be generated from one unit pixel pattern. Each of the luminance signal Y, the first color signal Cb, and the second color signal Cr may include spatial information about one unit pixel pattern.

Then, the image sensor 1000 may convert the luminance signal Y, the first color signal Cb, and the second color signal Cr that are analog signals into digital signals, and may generate image data of various digital formats. For example, the image sensor 1000 may selectively generate image data having one of a plurality of different digital image formats, e.g., YCbCr 444 format, YCbCr 422 format, and YCbCr 420 format, and output the image data to the outside, according to a request from another external device including the image sensor 1000. Alternatively, when the external device uses only one format, the image sensor 1000 may generate image data having only one set format from among the YCbCr 444 format, the YCbCr 422 format, and the YCbCr 420 format, and outputs the image data to the outside.

The image processing described with reference to FIG. 24 may be performed by, for example, the output circuit 1030 of the image sensor 1000. The output circuit 1030 may generate the luminance signal Y, the first color signal Cb, and the second color signal Cr that are analog signals, and may convert the analog signals into digital signals. Also, the output circuit 1030 may include a color formatter 1031 that is configured to selectively generate the image signal of the YCbCr 444 format, the YCbCr 422 format, or the YCbCr 420 format by using the digitalized luminance signal Y, the first color signal Cb, and the second color signal Cr.

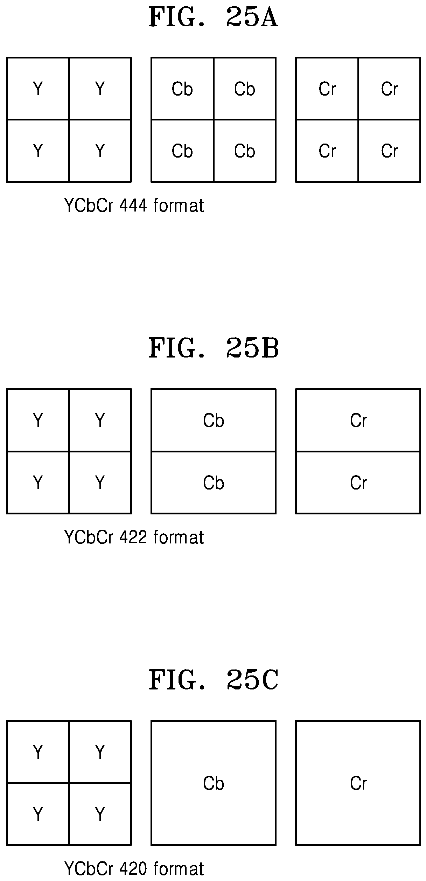

FIGS. 25A, 25B, and 25C are diagrams showing examples of image formats of FIG. 24. Referring to FIG. 25A, in the YCbCr 444 format, unit image data may include four luminance signals Y, four first color signals Cb, and four second color signals Cr. The four luminance signals Y, the four first color signals Cb, and the four second color signals Cr are obtained by combining outputs from four adjacent unit pixel patterns. When the image sensor 1000 provides an external electronic apparatus with the image data of the YCbCr 444 format, the external electronic apparatus may additionally process the image data of the YCbCr 444 format to be suitable for the usage.

Referring to FIG. 25B, in the YCbCr 422 format, unit image data may include four luminance signals Y, two first color signals Cb, and two second color signals Cr. In the case of the YCbCr422 format, from among four first color signals Cb in the YCbCr 444 format of FIG. 25A, two signals adjacent to each other in the horizontal direction are averaged to obtain two first color signals Cb. Also, from among four second color signals Cr in the YCbCr 444 format, two signals adjacent to each other in the horizontal direction are averaged to obtain two second color signals Cr. The YCbCr 422 format may be mainly used in, for example, a still image adopting the joint photographic experts group (JPEG) standard.

Referring to FIG. 25C, in the YCbCr 420 format, unit image data may include four luminance signals Y, one first color signal Cb, and one second color signal Cr. In the case of the YCbCr 420 format, four first color signals Cb of the YCbCr 444 format of FIG. 25A are averaged to obtain one first color signal Cb, and four second color signals Cr of the YCbCr 444 format are averaged to obtain one second color signal Cr. The YCbCr 420 format may be mainly used in, for example, a video adopting the moving picture experts group (MPEG)-4 standard.

As described above, the image sensor 1000 may perform the image processing without demosaicing, and thus, an operation amount for image processing may be reduced and an image processing speed may be improved, and the power consumption of the image sensor 1000 may be reduced. Also, when the image sensor 1000 outputs the image data of a certain image format through the above image processing, and operation amount of the processor in the external device including the image sensor 1000 may be also reduced and the operating speed of the external device may be improved.

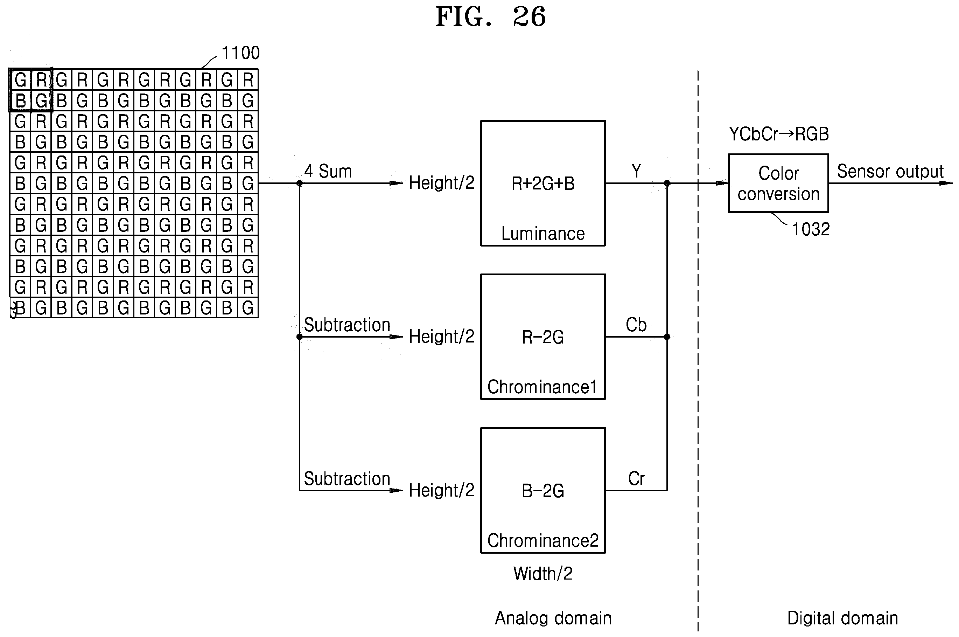

FIG. 26 is a diagram showing another example of image processing in the pre-process of FIG. 23. In FIG. 26, the process of generating the luminance signal Y, the first color signal Cb, and the second color signal Cr is the same as that of FIG. 24. Referring to FIG. 26, the output circuit 1030 may include a color converter 1032 that is configured to perform color conversion for generating digitalized RGB signals by using the digitalized luminance signal Y, the first color signal Cb, and the second color signal Cr. In general, the eyes of a human being have non-linear characteristics and are sensitive for brightness. Therefore, when the analog outputs from the red pixel, the green pixel, and the blue pixel are directly converted into the digital signals, the color of generated image data may not match the color perceived by the eyes of a human being. Also, when the digitalized RGB signals are generated after converting the luminance signal Y, the first color signal Cb, and the second color signal Cr, a data processing amount may be further reduced. The image sensor 1000 may selectively perform one of the image processing shown in FIG. 24 and shown in FIG. 26, according to the request from the external device. For example, when the external device requests digitalized RGB signals, the image sensor 1000 may perform the image processing shown in FIG. 26.

The image sensor 1000 according to the example embodiment may form a camera module along with a module lens of various functions and may be utilized in various electronic devices.

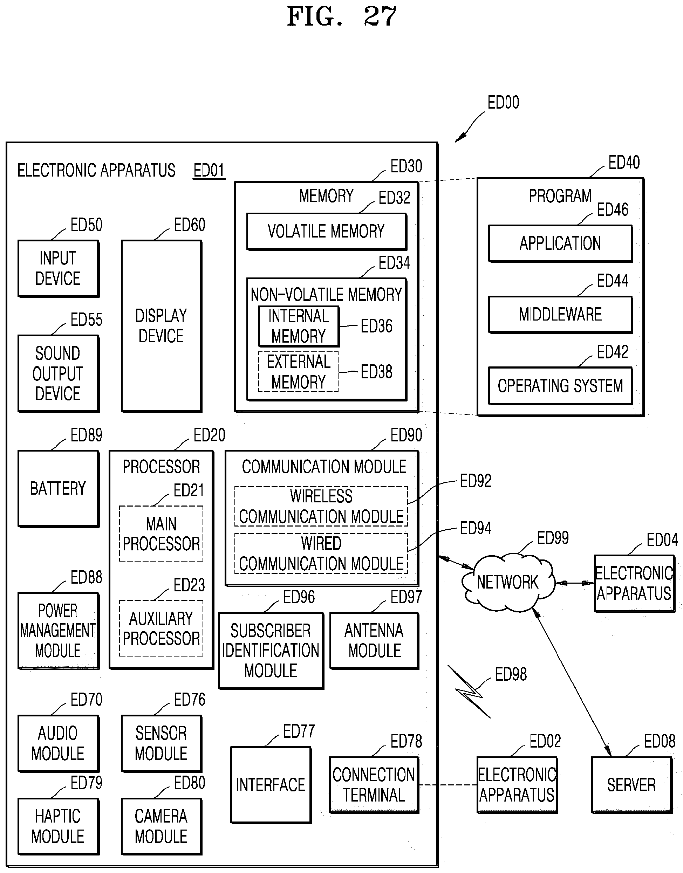

FIG. 27 is a block diagram showing an example of an electronic apparatus ED01 including an image sensor 1000. Referring to FIG. 27, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (the display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.) and may perform various data processing or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 a (central processing unit, an application processor, etc.) and an auxiliary processor ED23 (a graphics processing unit, an image signal processor, a sensor hub processor, a communication processor, etc.) that may operate independently from or along with the main processor ED21. The auxiliary processor ED23 may use less power than that of the main processor ED21 and may perform specific functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (the display device ED60, the sensor module ED76, the communication module ED90, etc.) of the elements in the electronic apparatus ED01. The auxiliary processor ED23 (an image signal processor, a communication processor, etc.) may be implemented as a part of another element (the camera module ED80, the communication module ED90, etc.) that is functionally related thereto.

The memory ED30 may store various data required by the elements (the processor ED20, the sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30 and may include an operation system ED42, middleware ED44, and/or an application ED46.

The input device ED50 may receive commands and/or data to be used in the elements (the processor ED20, etc.) of the electronic apparatus ED01, from outside (a user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include touch circuitry set to sense a touch, and/or a sensor circuit (pressure sensor, etc.) that is set to measure the strength of a force generated by the touch.

The audio module ED70 may convert sound into an electrical signal or vice versa. The audio module ED 70 may acquire sound through the input device ED50, or may output sound via the sound output device ED55 and/or a speaker and/or headphones of another electronic apparatus (the electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.) and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (the electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (the electronic apparatus ED02, etc.). The connection terminal ED78 may include an HDMI connector, a USB connector, an SD card connector, and/or an audio connector (headphones connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (the electronic apparatus ED02, the electronic apparatus ED04, the server ED08, etc.), and execution of communication through the established communication channel. The communication module ED90 may be operated independently from the processor ED20 (application processor, etc.) and may include one or more communication processors that support the direct communication and/or the wireless communication. The communication module ED90 may include a wireless communication module ED92 (a cellular communication module, a short-range wireless communication module, a global navigation satellite system (GNSS) communication module) and/or a wired communication module ED94 (a local area network (LAN) communication module, a power line communication module, etc.). From among the communication modules, a corresponding communication module may communicate with another electronic apparatus via the first network ED98 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

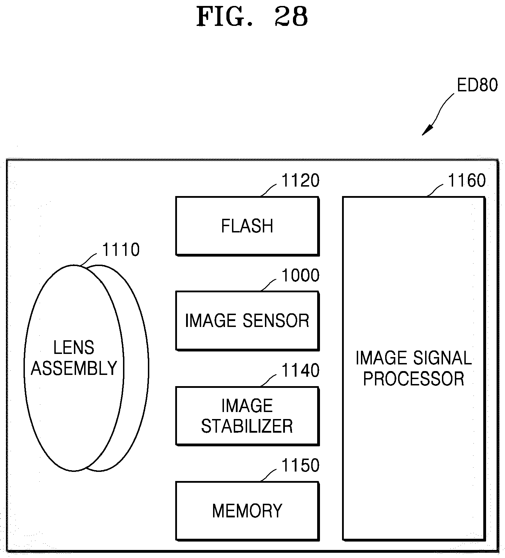

FIG. 28 is a block diagram showing an example of the camera module ED80 included in the electronic apparatus ED01 of FIG. 27. Referring to FIG. 28, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus 1101 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

An image signal processor 1160 may obtain an image by using electrical signals output from the image sensor 1000. For example, the image signal processor 1160 may directly perform some of the image processes shown in FIGS. 23 to 26, in connection with the image sensor 1000. Also, the image signal processor 1160 may request image data of a certain format from the image sensor 1000 according to the format of the necessary image data.

Also, the image signal processor 1160 may perform additional image processes on the image obtained through the image sensor 1000 or the image data stored in the memory 1150. The image processing may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80.

The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image processing by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 28, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

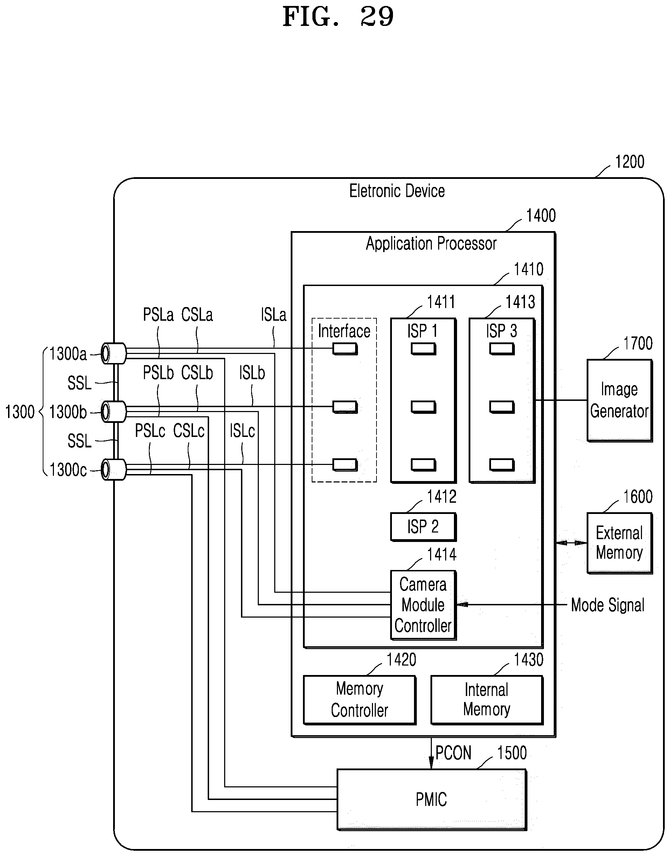

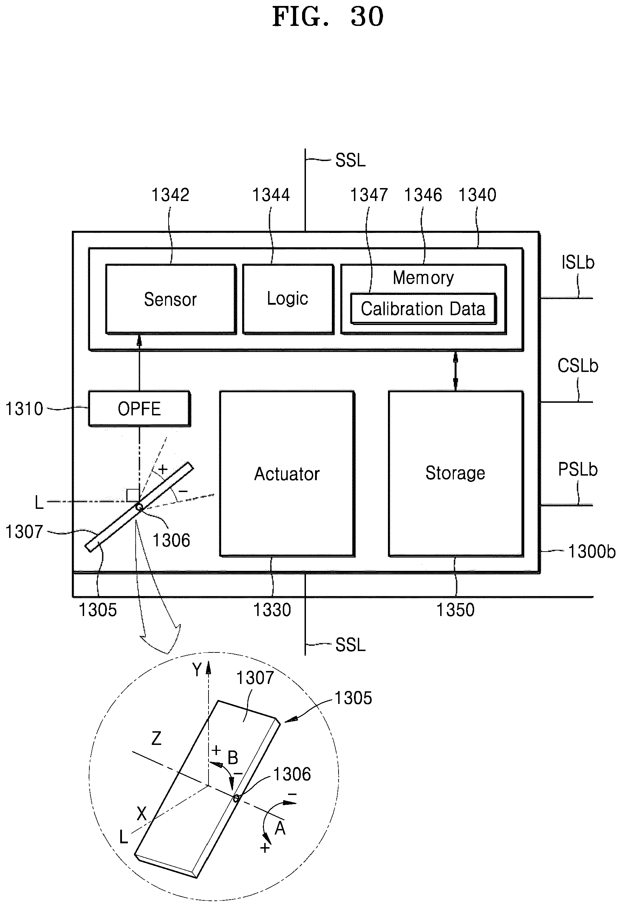

FIG. 29 is a block diagram of an electronic device 1200 including a multi-camera module, and FIG. 30 is a detailed block diagram of the camera module in the electronic device shown in FIG. 29.

Referring to FIG. 29, the electronic device 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. Although the drawings show an example in which three camera modules 1300a, 1300b, and 1300c are arranged, one or more embodiments are not limited thereto. In some embodiments, the camera module group 1300 may be modified to include only two camera modules. Also, in some embodiments, the camera module group 1300 may be modified to include n (n is 4 or greater natural number) camera modules.

Hereinafter, detailed configuration of one camera module 1300b is described in detail below with reference to FIG. 30, but the description provided below may be also applied to the other camera modules 1300a and 1300c according to the example embodiments.

Referring to FIG. 30, the camera module 1300b may include a prism 1305, an optical path folding element (OPFE) 1310, an actuator 1330, an image sensing device 1340, and a storage 1350.

The prism 1305 may include a reflecting surface 1307 having a light-reflecting material and may deform a path of light L incident from outside.

In some embodiments, the prism 1305 may change the path of the light L incident in the first direction (X-direction) into a second direction (Y-direction) that is perpendicular to the first direction (X-direction). Also, the prism 1305 may rotate the reflecting surface 1307 having the light-reflecting material about a center axis 1106 in a direction A, or about the center axis 1306 in a direction B such that the path of the light L incident in the first direction (X-direction) may be changed to the second direction (Y-direction) perpendicular to the first direction (X-direction). Here, the OPFE 1310 may also move in the third direction (Z-direction) that is perpendicular to the first direction (X-direction) and the second direction (Y-direction).

In some embodiments, as shown in the drawings, the maximum rotation angle of the prism 1305 in the direction A is 15° or less in the positive A direction and is greater than 15° in the negative A direction, but embodiments are not limited thereto.

In some embodiments, the prism 1305 may be moved by the angle of about 20°, or between 10° to 20° or 15° to 20° in the positive or negative B direction. Here, the moving angle is the same in the positive or negative B direction, or may be similar within a range of about 1°.

In some embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups (here, m is a natural number). Here, m lenses move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 or the optical lens (hereinafter, referred to as optical lens) to a certain position. For example, the actuator 1330 may adjust the position of the optical lens such that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to the above effects, the optical intensity required to generate high quality images of high resolution and under the low illuminance may be secured.

The memory 1346 may store information that is necessary for the operation of the camera module 1300b, e.g., calibration data 1347. The calibration data 1347 may include information that is necessary to generate image data by using the light L provided from outside through the camera module 1300b. The calibration data 1347 may include, for example, information about the degree of rotation described above, information about the focal length, information about an optical axis, etc. When the camera module 1300b is implemented in the form of a multi-state camera of which the focal length is changed according to the position of the optical lens, the calibration data 1347 may include information related to focal length values of the optical lens according to each position (or state) and auto-focusing.

The storage unit 1350 may store image data sensed through the image sensor 1342. The storage unit 1350 may be disposed out of the image sensing device 1340 and may be stacked with a sensor chip included in the image sensing device 1340. In some embodiments, the storage unit 1350 may be implemented as electrically erasable programmable read-only memory (EEPROM), but one or more embodiments are not limited thereto.

Referring to FIGS. 29 and 30, in some embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some embodiments, one (for example, 1300b) of the plurality of camera modules 1300a, 1300b, and 1300c may be a camera module in a folded lens type including the prism 1305 and the OPFE 1310 described above, and the other camera modules (for example, 1300a and 1300c) may be vertical type camera modules not including the prism 1305 and the OPFE 1310. However, the disclosure is not limited thereto.

In some embodiments, one (for example, 1300c) of the plurality of camera modules 1300a, 1300b, and 1300c may be a depth camera of a vertical type, which extracts depth information by using infrared ray (IR).

In some embodiments, at least two camera modules (e.g., 1300a and 1300b) from among the plurality of camera module 1300a, 1300b, and 1300c may have different fields of view. In this case, for example, the optical lenses of the at least two camera modules (e.g., 1300a and 1300b) from among the plurality of camera modules 1300a, 1300b, and 1300c may be different from each other, but one or more embodiments are not limited thereto.

Also, in some embodiments, the plurality of camera modules 1300a, 1300b, and 1300c may have different fields of view from one another. In this case, the optical lenses respectively included in the plurality of camera modules 1300a, 1300b, and 1300c may be different from one another, but the inventive concept is not limited thereto.

In some embodiments, the plurality of camera modules 1300a, 1300b, and 1300c may be physically isolated from one another. That is, the sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 29, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 via separate image signal lines ISLa, ISLb, and ISLc, respectively. The image data transfer may be carried out by using a camera serial interface (CSI) based on a mobile industry processor interface (MIPI), for example, but is not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. When the number of sub-processors is equal to the number of camera modules 1300a, 1300b, and 1300c, each of the sub-processors may process the image data provided from one camera module. When the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1412. The image processor 1412 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

For example, the image generator 1700 may generate by merging at least parts of the image data generated by the camera modules 1300a, 1300b, and 1300c having different fields of view, according to image generating information or the mode signal. Also, the image generator 1700 may generate the output image by selecting one of pieces of image data generated by the camera modules 1300a, 1300b, and 1300c having different fields of view, according to image generating information or the mode signal.

In some embodiments, the image generating information may include a zoom signal or a zoom factor. Also, in some embodiments, the mode signal may be, for example, a signal based on a mode selected by a user.

When the image generating information is a zoom signal (zoom factor) and the camera modules 1300a, 1300b, and 1300c have different fields of view (angles of view) from one another, the image generator 1700 may perform different operations according to the kind of zoom signal. For example, when the zoom signal is a first signal, the image data output from the camera module 1300a is merged with the image data output from the camera module 1300c, and then, the output image may be generated by using the merged image signal and the image data output from the camera module 1300b and not used in the merge. When the zoom signal is a second signal that is different from the first signal, the image generator 1700 may not perform the image data merging, and then, may generate the output image by selecting one piece of the image data output respectively from the camera modules 1300a, 1300b, and 1300c. However, one or more embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c via control signal lines CSLa, CSLb, and CSLc separated from one another.

In some embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encodes the image signal at a second speed that is faster than the first speed (for example, encoding the image signal of a second frame rate that is greater than the first frame rate), and transfers the encoded image signal to the application processor 1400. Here, the second speed may be 30 times faster than the first speed or less.

The application processor 1400 may store the received image signal, that is, the encoded mage signal, in the memory 1430 provided therein or the storage 1600 outside the application processor 1400, and after that, reads and decodes the encoded signal from the memory 1430 or the storage 1600, and may display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c generates an image signal at a third speed that is slower than the first speed (for example, generating the image signal of a third frame rate that is lower than the first frame rate), and may transfer the image signal to the application processor 1400. The image signal provided to the application processor 1400 may be a signal that is not encoded. The application processor 1400 may perform the image processing of the received image signal or store the image signal in the memory 1430 or the storage 1600.

The PMIC 1500 may supply the power, for example, the power voltage, to each of the plurality of camera modules 1300a, 1300b, and 1300c. For example, the PMIC 1500 may supply the first power to the camera module 1300a via a power signal line PSLa, the second power to the camera module 1300b via a power signal line PSLb, and the third power to the camera module 1300c via a power signal line PSLc, under the control of the application processor 1400.

The PMIC 1500 may generate the power corresponding to each of the plurality of camera modules 1300a, 1300b, and 1300c and may adjust the power level, in response to a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the low-power mode and set power level. The levels of the power provided to the plurality of camera modules 1300a, 1300b, and 1300c may be equal to or different from each other. Also, the power level may be dynamically changed.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor comprising:
a sensor substrate (110) comprising a plurality of unit pixel patterns that comprise a first pixel (111), a second pixel (112), a third pixel (113) and a fourth pixel (114) that are configured to sense light, the plurality of unit pixel patterns being two-dimensionally arranged in a first direction and a second direction; and
a nano-photonic lens array (130) comprising a plurality of unit meta-patterns that comprise a first meta-region (131), a second meta-region (132), a third meta-region (133) and a fourth meta-region (134) respectively corresponding to the first pixel, the second pixel, the third pixel, and the fourth pixel, the plurality of unit meta-patterns being two-dimensionally arranged in the first direction and the second direction,
wherein each of the first meta-region, the second meta-region, the third meta-region, and the fourth meta-region comprises a plurality of nano-structures (NP) that are configured to color-separate light incident on each unit meta-pattern of the plurality of unit meta-patterns included in the nano-photonic lens array and to condense the color-separated light onto the first pixel, the second pixel, the third pixel, and the fourth pixel,
wherein, in each unit meta-pattern of the plurality of unit meta-patterns, a distribution of cross-sectional areas of the plurality of nano-structures is asymmetrical in the first direction, the second direction, a first diagonal line direction, and a second diagonal line direction with respect to a center of each unit meta-pattern of the plurality of unit meta-patterns, and
wherein, in each unit meta-pattern of the plurality of unit meta-patterns, the distribution of the cross-sectional areas of the plurality of nano-structures in the first meta-region and the distribution of the cross-sectional areas of the plurality of nano-structures in the fourth meta-region are in a 180°-angle rotational symmetric relationship with respect to the center of each unit meta-pattern of the plurality of unit meta-patterns.

2. The image sensor of claim 1, wherein heights, positions, and periods of the plurality of nano-structures included in the first meta-region, the second meta-region, the third meta-region, and the fourth meta-region are equal to each other.

3. The image sensor of claim 1 or 2, wherein the distribution of the cross-sectional areas of the plurality of nano-structures in the first meta-region, a distribution of the cross-sectional areas of the plurality of nano-structures in the second meta-region, a distribution of the cross-sectional areas of the plurality of nano-structures in the third meta-region, and the distribution of the cross-sectional areas of the plurality of nano-structures in the fourth meta-region is determined such that color-separation and condensation of light occur independently in each unit meta-pattern of the plurality of unit meta-patterns without light exchange being generated among the plurality of unit meta-patterns.

4. The image sensor of any preceding claim, wherein the distribution of the cross-sectional areas of the plurality of nano-structures in the first meta-region is asymmetrical in the first direction, the second direction, the first diagonal line direction, and the second diagonal line direction with respect to the center of the first meta-region, and
wherein the distribution of the cross-sectional areas of the plurality of nano-structures in the fourth meta-region is asymmetrical in the first direction, the second direction, the first diagonal line direction, and the second diagonal line direction with respect to the center of the first meta-region, and optionally wherein: from among the plurality of nano-structures in the first meta-region, a phase delay of light transmitted by a nano-structure adjacent to the second meta-region and a phase delay of light transmitted by a nano-structure adjacent to the third meta-region are greater than phase delays of light transmitted by the other nano-structures; and
from among the plurality of nano-structures in the fourth meta-region, a phase delay of light transmitted by a nano-structure adjacent to the second meta-region and a phase delay of light transmitted by a nano-structure adjacent to the third meta-region are greater than phase delays of light transmitted by the other nano-structures.

5. The image sensor of any preceding claim, wherein, from among a plurality of pairs of two nano-structures facing each other in the second direction with respect to a horizontal center line passing through the center of the first meta-region in the first direction, cross sectional areas of at least one pair of nano-structures are different from each other,
wherein, from among a plurality of pairs of two nano-structures facing each other in the first direction with respect to a vertical center line passing through the center of the first meta-region in the second direction, cross sectional areas of at least one pair of nano-structures are different from each other,
wherein, from among a plurality of pairs of two nano-structures facing each other with respect to the first diagonal line passing through the center of the first meta-region, cross sectional areas of at least one pair of nano-structures are different from each other,
wherein, from among a plurality of pairs of two nano-structures facing each other with respect to the second diagonal line passing through the center of the first meta-region, cross sectional areas of at least one pair of nano-structures are different from each other, and
wherein, cross sectional areas of two nano-structures that are adjacent to a unit meta-pattern different from the unit meta-pattern comprising the first meta-region and face each other based on the second diagonal line are equal to each other.

6. The image sensor of any of claims 1 to 4, wherein, from among a plurality of pairs of two nano-structures facing each other in the second direction with respect to a horizontal center line passing through the center of the fourth meta-region in the first direction, cross sectional areas of at least one pair of nano-structures are different from each other,
wherein, from among a plurality of pairs of two nano-structures facing each other in the first direction with respect to a vertical center line passing through the center of the fourth meta-region in the second direction, cross sectional areas of at least one pair of nano-structures have are different from each other,
wherein, from among a plurality of pairs of two nano-structures facing each other with respect to the first diagonal line passing through the center of the fourth meta-region, cross sectional areas of at least one pair of nano-structures are different from each other, and
wherein, from among a plurality of pairs of two nano-structures facing each other with respect to the second diagonal line passing through the center of the fourth meta-region, cross sectional areas of at least one pair of nano-structures are different from each other, and optionally wherein cross sectional areas of two nano-structures that are adjacent to a unit meta-pattern different from the unit meta-pattern comprising the fourth meta-region and face each other based on the second diagonal line are equal to each other.

7. The image sensor of any preceding claim, wherein, in the second meta-region, the distribution of cross-sectional areas of the plurality of nano-structures is symmetrical in the first diagonal line direction and asymmetrical in the first direction, the second direction, and the second diagonal line direction based on a center of the second meta-region, and
wherein, in the third meta-region, the distribution of cross-sectional areas of the plurality of nano-structures is symmetrical in the first diagonal line direction and asymmetrical in the first direction, the second direction, and the second diagonal line direction based on a center of the third meta-region, and optionally wherein: from among the plurality of nano-structures in the second meta-region, a phase delay of light transmitted by a nano-structure adjacent to the first meta-region and a phase delay of light transmitted by a nano-structure adjacent to the fourth meta-region are greater than phase delays of light transmitted by the other nano-structures; and
from among the plurality of nano-structures in the third meta-region, a phase delay of light transmitted by a nano-structure adjacent to the first meta-region and a phase delay of light transmitted by a nano-structure adjacent to the fourth meta-region are greater than phase delays of light transmitted by the other nano-structures.

8. The image sensor of any preceding claim, wherein, in the second meta-region, cross sectional areas of two nano-structures facing each other with respect to the first diagonal line passing through the center of the second meta-region are equal to each other, and optionally wherein: from among a plurality of pairs of two nano-structures facing each other in the second direction with respect to a horizontal center line passing through the center of the second meta-region in the first direction, cross sectional areas of at least one pair of nano-structures are different from each other;
and, from among a plurality of pairs of two nano-structures facing each other in the first direction with respect to a vertical center line passing through the center of the second meta-region in the second direction, cross sectional areas of at least one pair of nano-structures are different from each other, and
wherein, from among a plurality of pairs of two nano-structures facing each other with respect to the second diagonal line passing through the center of the second meta-region, cross sectional areas of at least one pair of nano-structures are different from each other.

9. The image sensor of any of claims 1 to 7, wherein, in the third meta-region, cross sectional areas of two nano-structures facing each other with respect to the first diagonal line passing through the center of the third meta-region are equal to each other,
wherein, from among a plurality of pairs of two nano-structures facing each other in the second direction with respect to a horizontal center line passing through the center of the third meta-region in the first direction, cross sectional areas of at least one pair of nano-structures are different from each other,
wherein, from among a plurality of pairs of two nano-structures facing each other in the first direction with respect to a vertical center line passing through the center of the third meta-region in the second direction, cross sectional areas of at least one pair of nano-structures are different from each other, and
wherein, from among a plurality of pairs of two nano-structures facing each other with respect to the second diagonal line passing through the center of the third meta-region, cross sectional areas of at least one pair of nano-structures are different from each other.

10. The image sensor of any preceding claim, wherein, in the unit meta-pattern, phase delays of light transmitted by the nano-structures at a center portion of the unit meta-pattern are configured are greater phase delays than phase delays of light transmitted by the nano-structures that are directly adjacent to another unit meta-pattern.

11. The image sensor of any preceding claim, wherein, the plurality of nano-structures are configured to color-separate light incident on each unit meta-pattern in the nano-photonic lens array, and to condense light of a first wavelength band onto the first pixel and the fourth pixel, light of a second wavelength band onto the second pixel, and light of a third wavelength band onto the third pixel,
wherein, in one unit pixel pattern, the second pixel and the third pixel are provided in the first diagonal line direction, and the first pixel and the fourth pixel are provided in the second diagonal line direction crossing the first diagonal line direction, and
wherein, in one unit meta-pattern, the second meta-region and the third meta-region are arranged in the first diagonal line direction and the first meta-region and the fourth meta-region are arranged in the second diagonal line direction.

12. The image sensor of any preceding claim, further comprising:
a plurality of isolation patterns on an upper surface of the nano-photonic lens array,
wherein each of the plurality of isolation patterns faces the first meta-region, the second meta-region, the third meta-region, and the fourth meta-region included in a corresponding unit meta-pattern from among the plurality of unit meta-patterns, and
wherein each isolation pattern from among the plurality of isolation patterns has a flat upper surface, an irregularly uneven upper surface, or a convex upper surface.

13. The image sensor of any preceding claim, wherein the image sensor, in each unit pixel pattern of the plurality of unit pixel patterns, is configured to:
generate a luminance signal by summing an output from the first pixel, an output from the second pixel, an output from the third pixel, and an output from the fourth pixel;
generate a first color signal by subtracting the output from the first pixel and the output from the fourth pixel from the output from the third pixel; and
generate a second color signal by subtracting the output from the first pixel and the output from the fourth pixel from the output from the second pixel.

14. The image sensor of claim 13, wherein the image sensor is further configured to:
convert the luminance signal, the first color signal, and the second color signal into digital signals;
selectively generate image data having one of a plurality of digital image formats based on a digitalized luminance signal, the first color signal, and the second color signal; and
output the image data external to the image sensor.

15. An electronic apparatus comprising:
a lens assembly configured to form an optical image of a subject;
an image sensor according to any preceding claim configured to convert, into an electrical signal, the optical image formed by the lens assembly; and
a processor configured to process the electrical signal generated by the image sensor.

## Patentansprüche

1. Bildsensor, umfassend:
ein Sensorsubstrat (110), umfassend eine Vielzahl von Einheitspixelmustern, die ein erstes Pixel (111), ein zweites Pixel (112), ein drittes Pixel (113) und ein viertes Pixel (114) umfassen, die dazu konfiguriert sind, Licht zu erfassen, wobei die Vielzahl von Einheitspixelmustern zweidimensional in einer ersten Richtung und einer zweiten Richtung angeordnet ist; und
ein nanophotonisches Linsenarray (130), umfassend eine Vielzahl von Einheitsmetamustern, die eine erste Metaregion (131), eine zweite Metaregion (132), eine dritte Metaregion (133) und eine vierte Metaregion (134) umfassen, die dem ersten Pixel, dem zweiten Pixel, dem dritten Pixel bzw. dem vierten Pixel entsprechen, wobei die Vielzahl von Einheitsmetamustern zweidimensional in der ersten Richtung und der zweiten Richtung angeordnet ist,
wobei jede der ersten Metaregion, der zweiten Metaregion, der dritten Metaregion und der vierten Metaregion eine Vielzahl von Nanostrukturen (NP) umfasst, die dazu konfiguriert sind, Licht, das auf jedes Einheitsmetamuster der Vielzahl von Einheitsmetamustern einfällt, die in dem nanophotonischen Linsenarray eingeschlossen sind, farblich zu trennen und das farblich getrennte Licht auf das erste Pixel, das zweite Pixel, das dritte Pixel und das vierte Pixel zu kondensieren,
wobei in jedem Einheitsmetamuster der Vielzahl von Einheitsmetamustern eine Verteilung von Querschnittsflächen der Vielzahl von Nanostrukturen in der ersten Richtung, der zweiten Richtung, einer ersten Diagonallinienrichtung und einer zweiten Diagonallinienrichtung in Bezug auf eine Mitte jedes Einheitsmetamusters der Vielzahl von Einheitsmetamustern asymmetrisch ist und
wobei in jedem Einheitsmetamuster der Vielzahl von Einheitsmetamustern die Verteilung der Querschnittsflächen der Vielzahl von Nanostrukturen in der ersten Metaregion und die Verteilung der Querschnittsflächen der Vielzahl von Nanostrukturen in der vierten Metaregion in einer 180°-Winkel-Rotationssymmetriebeziehung in Bezug auf die Mitte jedes Einheitsmetamusters der Vielzahl von Einheitsmetamustern stehen.

2. Bildsensor nach Anspruch 1, wobei Höhen, Positionen und Perioden der Vielzahl von Nanostrukturen, die in der ersten Metaregion, der zweiten Metaregion, der dritten Metaregion und der vierten Metaregion eingeschlossen sind, einander gleich sind.

3. Bildsensor nach Anspruch 1 oder 2, wobei die Verteilung der Querschnittsflächen der Vielzahl von Nanostrukturen in der ersten Metaregion, eine Verteilung der Querschnittsflächen der Vielzahl von Nanostrukturen in der zweiten Metaregion, eine Verteilung der Querschnittsflächen der Vielzahl von Nanostrukturen in der dritten Metaregion und die Verteilung der Querschnittsflächen der Vielzahl von Nanostrukturen in der vierten Metaregion derart bestimmt sind, dass farbliche Trennung und Kondensierung von Licht unabhängig in jedem Einheitsmetamuster der Vielzahl von Einheitsmetamustern auftreten, ohne dass Lichtaustausch zwischen der Vielzahl von Einheitsmetamustern erzeugt wird.

4. Bildsensor nach einem vorhergehenden Anspruch, wobei die Verteilung der Querschnittsflächen der Vielzahl von Nanostrukturen in der ersten Metaregion in der ersten Richtung, der zweiten Richtung, der ersten Diagonallinienrichtung und der zweiten Diagonallinienrichtung in Bezug auf die Mitte der ersten Metaregion asymmetrisch ist und
wobei die Verteilung der Querschnittsflächen der Vielzahl von Nanostrukturen in der vierten Metaregion in der ersten Richtung, der zweiten Richtung, der ersten Diagonallinienrichtung und der zweiten Diagonallinienrichtung in Bezug auf die Mitte der ersten Metaregion asymmetrisch ist und wobei optional: aus der Vielzahl von Nanostrukturen in der ersten Metaregion eine Phasenverzögerung von Licht, das durch eine Nanostruktur benachbart zu der zweiten Metaregion durchgelassen wird, und eine Phasenverzögerung von Licht, das durch eine Nanostruktur benachbart zu der dritten Metaregion durchgelassen wird, größer sind als Phasenverzögerungen von Licht, das durch die anderen Nanostrukturen durchgelassen wird; und
aus der Vielzahl von Nanostrukturen in der vierten Metaregion eine Phasenverzögerung von Licht, das durch eine Nanostruktur benachbart zu der zweiten Metaregion durchgelassen wird, und eine Phasenverzögerung von Licht, das durch eine Nanostruktur benachbart zu der dritten Metaregion durchgelassen wird, größer sind als Phasenverzögerungen von Licht, das durch die anderen Nanostrukturen durchgelassen wird.

5. Bildsensor nach einem vorhergehenden Anspruch, wobei aus einer Vielzahl von Paaren von zwei Nanostrukturen, die einander in der zweiten Richtung in Bezug auf eine horizontale Mittellinie gegenüberliegen, die durch die Mitte der ersten Metaregion in der ersten Richtung verläuft, Querschnittsflächen mindestens eines Paars von Nanostrukturen voneinander unterschiedlich sind,
wobei aus einer Vielzahl von Paaren von zwei Nanostrukturen, die einander in der ersten Richtung in Bezug auf eine vertikale Mittellinie gegenüberliegen, die durch die Mitte der ersten Metaregion in der zweiten Richtung verläuft, Querschnittsflächen mindestens eines Paars von Nanostrukturen voneinander unterschiedlich sind,
wobei aus einer Vielzahl von Paaren von zwei Nanostrukturen, die einander in Bezug auf die erste Diagonallinie gegenüberliegen, die durch die Mitte der ersten Metaregion verläuft, Querschnittsflächen mindestens eines Paars von Nanostrukturen voneinander unterschiedlich sind,
wobei aus einer Vielzahl von Paaren von zwei Nanostrukturen, die einander in Bezug auf die zweite Diagonallinie gegenüberliegen, die durch die Mitte der ersten Metaregion verläuft, Querschnittsflächen mindestens eines Paars von Nanostrukturen voneinander unterschiedlich sind und
wobei Querschnittsflächen von zwei Nanostrukturen, die benachbart zu einem Einheitsmetamuster sind, das von dem die erste Metaregion umfassenden Einheitsmetamuster unterschiedlich ist, und einander basierend auf der zweiten Diagonallinie zugewandt sind, einander gleich sind.

6. Bildsensor nach einem der Ansprüche 1 bis 4, wobei aus einer Vielzahl von Paaren von zwei Nanostrukturen, die einander in der zweiten Richtung in Bezug auf eine horizontale Mittellinie gegenüberliegen, die durch die Mitte der vierten Metaregion in der ersten Richtung verläuft, Querschnittsflächen mindestens eines Paars von Nanostrukturen voneinander unterschiedlich sind,
wobei aus einer Vielzahl von Paaren von zwei Nanostrukturen, die einander in der ersten Richtung in Bezug auf eine vertikale Mittellinie gegenüberliegen, die durch die Mitte der vierten Metaregion in der zweiten Richtung verläuft, Querschnittsflächen mindestens eines Paars von Nanostrukturen aufweisen voneinander unterschiedlich sind,
wobei aus einer Vielzahl von Paaren von zwei Nanostrukturen, die einander in Bezug auf die erste Diagonallinie gegenüberliegen, die durch die Mitte der vierten Metaregion verläuft, Querschnittsflächen mindestens eines Paars von Nanostrukturen voneinander unterschiedlich sind und
wobei aus einer Vielzahl von Paaren von zwei Nanostrukturen, die einander in Bezug auf die zweite Diagonallinie gegenüberliegen, die durch die Mitte der vierten Metaregion verläuft, Querschnittsflächen mindestens eines Paars von Nanostrukturen voneinander unterschiedlich sind und wobei optional Querschnittsflächen von zwei Nanostrukturen, die benachbart zu einem Einheitsmetamuster sind, das von dem die vierte Metaregion umfassenden Einheitsmetamuster unterschiedlich ist, und einander basierend auf der zweiten Diagonallinie zugewandt sind, einander gleich sind.

7. Bildsensor nach einem vorhergehenden Anspruch, wobei in der zweiten Metaregion die Verteilung von Querschnittsflächen der Vielzahl von Nanostrukturen in der ersten Diagonallinienrichtung symmetrisch und in der ersten Richtung, der zweiten Richtung und der zweiten Diagonallinienrichtung basierend auf einer Mitte der zweiten Metaregion asymmetrisch ist und
wobei in der dritten Metaregion die Verteilung von Querschnittsflächen der Vielzahl von Nanostrukturen in der ersten Diagonallinienrichtung symmetrisch und in der ersten Richtung, der zweiten Richtung und der zweiten Diagonallinienrichtung basierend auf einer Mitte der dritten Metaregion asymmetrisch ist und wobei optional: aus der Vielzahl von Nanostrukturen in der zweiten Metaregion eine Phasenverzögerung von Licht, das durch eine Nanostruktur benachbart zu der ersten Metaregion durchgelassen wird, und eine Phasenverzögerung von Licht, das durch eine Nanostruktur benachbart zu der vierten Metaregion durchgelassen wird, größer sind als Phasenverzögerungen von Licht, das durch die anderen Nanostrukturen durchgelassen wird; und
aus der Vielzahl von Nanostrukturen in der dritten Metaregion eine Phasenverzögerung von Licht, das durch eine Nanostruktur benachbart zu der ersten Metaregion durchgelassen wird, und eine Phasenverzögerung von Licht, das durch eine Nanostruktur benachbart zu der vierten Metaregion durchgelassen wird, größer sind als Phasenverzögerungen von Licht, das durch die anderen Nanostrukturen durchgelassen wird.

8. Bildsensor nach einem vorhergehenden Anspruch, wobei in der zweiten Metaregion Querschnittsflächen von zwei Nanostrukturen, die einander in Bezug auf die erste Diagonallinie gegenüberliegen, die durch die Mitte der zweiten Metaregion verläuft, einander gleich sind und wobei optional: aus einer Vielzahl von Paaren von zwei Nanostrukturen, die einander in der zweiten Richtung in Bezug auf eine horizontale Mittellinie gegenüberliegen, die durch die Mitte der zweiten Metaregion in der ersten Richtung verläuft, Querschnittsflächen mindestens eines Paars von Nanostrukturen voneinander unterschiedlich sind;
und aus einer Vielzahl von Paaren von zwei Nanostrukturen, die einander in der ersten Richtung in Bezug auf eine vertikale Mittellinie gegenüberliegen, die durch die Mitte der zweiten Metaregion in der zweiten Richtung verläuft, Querschnittsflächen mindestens eines Paars von Nanostrukturen voneinander unterschiedlich sind und
wobei aus einer Vielzahl von Paaren von zwei Nanostrukturen, die einander in Bezug auf die zweite Diagonallinie gegenüberliegen, die durch die Mitte der zweiten Metaregion verläuft, Querschnittsflächen mindestens eines Paars von Nanostrukturen voneinander unterschiedlich sind.

9. Bildsensor nach einem der Ansprüche 1 bis 7, wobei in der dritten Metaregion Querschnittsflächen von zwei Nanostrukturen, die einander in Bezug auf die erste Diagonallinie gegenüberliegen, die durch die Mitte der dritten Metaregion verläuft, einander gleich sind,
wobei aus einer Vielzahl von Paaren von zwei Nanostrukturen, die einander in der zweiten Richtung in Bezug auf eine horizontale Mittellinie gegenüberliegen, die durch die Mitte der dritten Metaregion in der ersten Richtung verläuft, Querschnittsflächen mindestens eines Paars von Nanostrukturen voneinander unterschiedlich sind,
wobei aus einer Vielzahl von Paaren von zwei Nanostrukturen, die einander in der ersten Richtung in Bezug auf eine vertikale Mittellinie gegenüberliegen, die durch die Mitte der dritten Metaregion in der zweiten Richtung verläuft, Querschnittsflächen mindestens eines Paars von Nanostrukturen voneinander unterschiedlich sind und
wobei aus einer Vielzahl von Paaren von zwei Nanostrukturen, die einander in Bezug auf die zweite Diagonallinie gegenüberliegen, die durch die Mitte der dritten Metaregion verläuft, Querschnittsflächen mindestens eines Paars von Nanostrukturen voneinander unterschiedlich sind.

10. Bildsensor nach einem vorhergehenden Anspruch, wobei in dem Einheitsmetamuster Phasenverzögerungen von Licht, das durch die Nanostrukturen an einem mittigen Abschnitt des Einheitsmetamusters durchgelassen wird, konfiguriert sind größere Phasenverzögerungen sind als Phasenverzögerungen von Licht, das durch die Nanostrukturen durchgelassen wird, die direkt benachbart zu einem anderen Einheitsmetamuster sind.

11. Bildsensor nach einem vorhergehenden Anspruch, wobei die Vielzahl von Nanostrukturen dazu konfiguriert ist, Licht, das auf jedes Einheitsmetamuster in dem nanophotonischen Linsenarray einfällt, farblich zu trennen und Licht eines ersten Wellenlängenbands auf das erste Pixel und das vierte Pixel, Licht eines zweiten Wellenlängenbands auf das zweite Pixel und Licht eines dritten Wellenlängenbands auf das dritte Pixel zu kondensieren,
wobei in einem Einheitspixelmuster das zweite Pixel und das dritte Pixel in der ersten Diagonallinienrichtung bereitgestellt sind und das erste Pixel und das vierte Pixel in der zweiten Diagonallinienrichtung bereitgestellt sind, die die erste Diagonallinienrichtung kreuzt, und
wobei in einem Einheitsmetamuster die zweite Metaregion und die dritte Metaregion in der ersten Diagonallinienrichtung angeordnet sind und die erste Metaregion und die vierte Metaregion in der zweiten Diagonallinienrichtung angeordnet sind.

12. Bildsensor nach einem vorhergehenden Anspruch, ferner umfassend:
eine Vielzahl von Isolationsmustern auf einer oberen Oberfläche des nanophotonischen Linsenarrays,
wobei jedes der Vielzahl von Isolationsmustern der ersten Metaregion, der zweiten Metaregion, der dritten Metaregion und der vierten Metaregion zugewandt ist, die in einem entsprechenden Einheitsmetamuster aus der Vielzahl von Einheitsmetamustern eingeschlossen sind, und
wobei jedes Isolationsmuster aus der Vielzahl von Isolationsmustern eine flache obere Oberfläche, eine unregelmäßig unebene obere Oberfläche oder eine konvexe obere Oberfläche aufweist.

13. Bildsensor nach einem vorhergehenden Anspruch, wobei der Bildsensor in jedem Einheitspixelmuster der Vielzahl von Einheitspixelmustern zu Folgendem konfiguriert ist:
Erzeugen eines Luminanzsignals durch Summieren einer Ausgabe aus dem ersten Pixel, einer Ausgabe aus dem zweiten Pixel, einer Ausgabe aus dem dritten Pixel und einer Ausgabe aus dem vierten Pixel;
Erzeugen eines ersten Farbsignals durch Subtrahieren der Ausgabe aus dem ersten Pixel und der Ausgabe aus dem vierten Pixel von der Ausgabe aus dem dritten Pixel; und
Erzeugen eines zweiten Farbsignals durch Subtrahieren der Ausgabe aus dem ersten Pixel und der Ausgabe aus dem vierten Pixel von der Ausgabe aus dem zweiten Pixel.

14. Bildsensor nach Anspruch 13, wobei der Bildsensor ferner zu Folgendem konfiguriert ist:
Umwandeln des Luminanzsignals, des ersten Farbsignals und des zweiten Farbsignals in Digitalsignale;
selektivem Erzeugen von Bilddaten mit einem einer Vielzahl von digitalen Bildformaten basierend auf einem digitalisierten Luminanzsignal, dem ersten Farbsignal und dem zweiten Farbsignal; und
Ausgeben der Bilddaten außerhalb des Bildsensors.

15. Elektronische Vorrichtung, umfassend:
eine Linsenbaugruppe, die dazu konfiguriert ist, ein optisches Bild eines Subjekts auszubilden;
einen Bildsensor gemäß einem vorhergehenden Anspruch, der dazu konfiguriert ist, das durch die Linsenbaugruppe ausgebildete optische Bild in ein elektrisches Signal umzuwandeln; und
einen Prozessor, der dazu konfiguriert ist, das durch den Bildsensor erzeugte elektrische Signal zu verarbeiten.

## Revendications

1. Capteur d'image comprenant :
un substrat de capteur (110) comprenant une pluralité de motifs de pixels unitaires qui comprennent un premier pixel (111), un deuxième pixel (112), un troisième pixel (113) et un quatrième pixel (114) qui sont conçus pour détecter la lumière, la pluralité de motifs de pixels unitaires étant agencés bidimensionnellement dans une première direction et une seconde direction ; et
un réseau de lentilles nanophotoniques (130) comprenant une pluralité de métamotifs unitaires qui comprennent une première métazone (131), une deuxième métazone (132), une troisième métazone (133) et une quatrième métazone (134) correspondant respectivement au premier pixel, au deuxième pixel, au troisième pixel et au quatrième pixel, la pluralité de métamotifs unitaires étant agencés bidimensionnellement dans la première direction et la seconde direction,
chacune de la première métazone, de la deuxième métazone, de la troisième métazone et de la quatrième métazone comprenant une pluralité de nanostructures (NP) qui sont conçues pour séparer en couleurs la lumière incidente sur chaque métamotif unitaire de la pluralité de métamotifs unitaires compris dans le réseau de lentilles nanophotoniques et pour condenser la lumière séparée en couleurs sur le premier pixel, le deuxième pixel, le troisième pixel et le quatrième pixel,
dans chaque métamotif unitaire de la pluralité de métamotifs unitaires, une distribution des aires de section transversale de la pluralité de nanostructures étant asymétrique dans la première direction, la seconde direction, une première direction de ligne diagonale et une seconde direction de ligne diagonale par rapport à un centre de chaque métamotif unitaire de la pluralité de métamotifs unitaires, et
dans chaque métamotif unitaire de la pluralité de métamotifs unitaires, ladite distribution des aires de section transversale de la pluralité de nanostructures dans la première métazone et ladite distribution des aires de section transversale de la pluralité de nanostructures dans la quatrième métazone étant dans une relation de symétrie de rotation d'angle de 180° par rapport au centre de chaque métamotif unitaire de la pluralité de métamotifs unitaires.

2. Capteur d'image de la revendication 1, lesdites hauteurs, lesdites positions et lesdites périodes de la pluralité de nanostructures comprises dans la première métazone, la deuxième métazone, la troisième métazone et la quatrième métazone étant égales les unes aux autres.

3. Capteur d'image de la revendication 1 ou 2, ladite distribution des aires de section transversale de la pluralité de nanostructures dans la première métazone, une distribution des aires de section transversale de la pluralité de nanostructures dans la deuxième métazone, une distribution des aires de section transversale de la pluralité de nanostructures dans la troisième métazone, et la distribution des aires de section transversale de la pluralité de nanostructures dans la quatrième métazone étant déterminées de sorte que la séparation en couleurs et la condensation de la lumière se produisent indépendamment dans chaque métamotif unitaire de la pluralité de métamotifs unitaires sans qu'un échange de lumière ne soit généré parmi la pluralité de métamotifs unitaires.

4. Capteur d'image d'une quelconque revendication précédente, ladite distribution des aires de section transversale de la pluralité de nanostructures dans la première métazone étant asymétrique dans la première direction, la seconde direction, la première direction de ligne diagonale et la seconde direction de ligne diagonale par rapport au centre de la première métazone, et
ladite distribution des aires de section transversale de la pluralité de nanostructures dans la quatrième métazone étant asymétrique dans la première direction, la seconde direction, la première direction de ligne diagonale et la seconde direction de ligne diagonale par rapport au centre de la première métazone, et éventuellement : parmi la pluralité de nanostructures dans la première métazone, un retard de phase de la lumière transmise par une nanostructure adjacente à la deuxième métazone et un retard de phase de la lumière transmise par une nanostructure adjacente à la troisième métazone étant supérieurs à des retards de phase de la lumière transmise par les autres nanostructures ; et
parmi la pluralité de nanostructures dans la quatrième métazone, un retard de phase de la lumière transmise par une nanostructure adjacente à la deuxième métazone et un retard de phase de la lumière transmise par une nanostructure adjacente à la troisième métazone étant supérieurs aux retards de phase de la lumière transmise par les autres nanostructures.

5. Capteur d'image d'une quelconque revendication précédente, parmi une pluralité de paires de deux nanostructures se faisant face dans la seconde direction par rapport à une ligne centrale horizontale passant par le centre de la première métazone dans la première direction, des aires de section transversale d'au moins une paire de nanostructures étant différentes l'une de l'autre,
parmi une pluralité de paires de deux nanostructures se faisant face dans la première direction par rapport à une ligne centrale verticale passant à travers le centre de la première métazone dans la seconde direction, des aires de section transversale d'au moins une paire de nanostructures étant différentes l'une de l'autre,
parmi une pluralité de paires de deux nanostructures se faisant face par rapport à la première ligne diagonale passant par le centre de la première métazone, des aires de section transversale d'au moins une paire de nanostructures étant différentes l'une de l'autre,
parmi une pluralité de paires de deux nanostructures se faisant face par rapport à la seconde ligne diagonale passant par le centre de la première métazone, des aires de section transversale d'au moins une paire de nanostructures étant différentes l'une de l'autre, et
lesdites aires de section transversale de deux nanostructures qui sont adjacentes à un métamotif unitaire différent du métamotif unitaire comprenant la première métazone et se faisant face sur la base de la seconde ligne diagonale étant égales l'une à l'autre.

6. Capteur d'image de l'une quelconque des revendications 1 à 4, parmi une pluralité de paires de deux nanostructures se faisant face dans la seconde direction par rapport à une ligne centrale horizontale passant par le centre de la quatrième métazone dans la première direction, des aires de section transversale d'au moins une paire de nanostructures étant différentes l'une de l'autre,
parmi une pluralité de paires de deux nanostructures se faisant face dans la première direction par rapport à une ligne centrale verticale passant par le centre de la quatrième métazone dans la seconde direction, des aires de section transversale d'au moins une paire de nanostructures comportant étant différentes l'une de l'autre,
parmi une pluralité de paires de deux nanostructures se faisant face par rapport à la première ligne diagonale passant par le centre de la quatrième métazone, des aires de section transversale d'au moins une paire de nanostructures étant différentes l'une de l'autre, et
parmi une pluralité de paires de deux nanostructures se faisant face par rapport à la seconde ligne diagonale passant par le centre de la quatrième métazone, des aires de section transversale d'au moins une paire de nanostructures étant différentes l'une de l'autre, et éventuellement des aires de section transversale de deux nanostructures qui sont adjacentes à un métamotif unitaire différent du métamotif unitaire comprenant la quatrième métazone et se faisant face sur la base de la seconde ligne diagonale étant égales l'une à l'autre.

7. Capteur d'image d'une quelconque revendication précédente, dans la deuxième métazone, ladite distribution des aires de section transversale de la pluralité de nanostructures étant symétrique dans la première direction de ligne diagonale et asymétrique dans la première direction, la seconde direction et la seconde direction de ligne diagonale sur la base d'un centre de la deuxième métazone, et
dans la troisième métazone, ladite distribution des aires de section transversale de la pluralité de nanostructures étant symétrique dans la première direction de ligne diagonale et asymétrique dans la première direction, la seconde direction et la seconde direction de ligne diagonale sur la base d'un centre de la troisième métazone, et éventuellement : parmi la pluralité de nanostructures dans la deuxième métazone, un retard de phase de la lumière transmise par une nanostructure adjacente à la première métazone et un retard de phase de la lumière transmise par une nanostructure adjacente à la quatrième métazone étant supérieurs à des retards de phase de la lumière transmise par les autres nanostructures ; et
parmi la pluralité de nanostructures dans la troisième métazone, un retard de phase de la lumière transmise par une nanostructure adjacente à la première métazone et un retard de phase de la lumière transmise par une nanostructure adjacente à la quatrième métazone étant supérieurs aux retards de phase de la lumière transmise par les autres nanostructures.

8. Capteur d'image d'une quelconque revendication précédente, dans la deuxième métazone, des aires de section transversale de deux nanostructures se faisant face par rapport à la première ligne diagonale passant par le centre de la deuxième métazone étant égales l'une à l'autre, et éventuellement : parmi une pluralité de paires de deux nanostructures se faisant face dans la seconde direction par rapport à une ligne centrale horizontale passant par le centre de la deuxième métazone dans la première direction, des aires de section transversale d'au moins une paire de nanostructures étant différentes l'une de l'autre ;
et, parmi une pluralité de paires de deux nanostructures se faisant face dans la première direction par rapport à une ligne centrale verticale passant par le centre de la deuxième métazone dans la seconde direction, des aires de section transversale d'au moins une paire de nanostructures étant différentes l'une de l'autre, et
parmi une pluralité de paires de deux nanostructures se faisant face par rapport à la seconde ligne diagonale passant par le centre de la deuxième métazone, des aires de section transversale d'au moins une paire de nanostructures étant différentes l'une de l'autre.

9. Capteur d'image d'une quelconque des revendications 1 à 7, dans la troisième métazone, des aires de section transversale de deux nanostructures se faisant face par rapport à la première ligne diagonale passant par le centre de la troisième métazone étant égales l'une à l'autre,
parmi une pluralité de paires de deux nanostructures se faisant face dans la seconde direction par rapport à une ligne centrale horizontale passant par le centre de la troisième métazone dans la première direction, des aires de section transversale d'au moins une paire de nanostructures étant différentes l'une de l'autre,
parmi une pluralité de paires de deux nanostructures se faisant face dans la première direction par rapport à une ligne centrale verticale passant par le centre de la troisième métazone dans la seconde direction, des aires de section transversale d'au moins une paire de nanostructures étant différentes l'une de l'autre, et
parmi une pluralité de paires de deux nanostructures se faisant face par rapport à la seconde ligne diagonale passant par le centre de la troisième métazone, des aires de section transversale d'au moins une paire de nanostructures étant différentes l'une de l'autre.

10. Capteur d'image d'une quelconque revendication précédente, dans le métamotif unitaire, des retards de phase de la lumière transmise par les nanostructures au niveau d'une partie centrale du métamotif unitaire étant conçus étant des retards de phase supérieurs aux retards de phase de la lumière transmise par les nanostructures qui sont directement adjacentes à un autre métamotif unitaire.

11. Capteur d'image d'une quelconque revendication précédente, ladite pluralité de nanostructures étant conçues pour séparer en couleurs la lumière incidente sur chaque métamotif unitaire dans le réseau de lentilles nanophotoniques, et pour condenser la lumière d'une première bande de longueurs d'onde sur le premier pixel et le quatrième pixel, la lumière d'une deuxième bande de longueurs d'onde sur le deuxième pixel et la lumière d'une troisième bande de longueurs d'onde sur le troisième pixel,
dans un motif de pixel unitaire, ledit deuxième pixel et ledit troisième pixel étant disposés dans la première direction de ligne diagonale, et ledit premier pixel et ledit quatrième pixel étant disposés dans la seconde direction de ligne diagonale croisant la première direction de ligne diagonale, et
dans un métamotif unitaire, ladite seconde métazone et ladite troisième métazone étant agencées dans la première direction de ligne diagonale et ladite première métazone et ladite quatrième métazone étant agencées dans la seconde direction de ligne diagonale.

12. Capteur d'image d'une quelconque revendication précédente, comprenant en outre :
une pluralité de motifs d'isolation sur une surface supérieure du réseau de lentilles nanophotoniques,
chacun de la pluralité de motifs d'isolation faisant face à la première métazone, à la deuxième métazone, à la troisième métazone et à la quatrième métazone comprises dans un métamotif unitaire correspondant parmi la pluralité de métamotifs unitaires, et
chaque motif d'isolation parmi la pluralité de motifs d'isolation possédant une surface supérieure plate, une surface supérieure irrégulièrement inégale ou une surface supérieure convexe.

13. Capteur d'image d'une quelconque revendication précédente, ledit capteur d'image, dans chaque motif de pixels unitaire de la pluralité de motifs de pixels unitaires, étant conçu pour :
générer un signal de luminance en additionnant une sortie du premier pixel, une sortie du deuxième pixel, une sortie du troisième pixel et une sortie du quatrième pixel ;
générer un premier signal de couleur en soustrayant la sortie du premier pixel et la sortie du quatrième pixel de la sortie du troisième pixel ; et
générer un second signal de couleur en soustrayant la sortie du premier pixel et la sortie du quatrième pixel de la sortie du deuxième pixel.

14. Capteur d'image de la revendication 13, ledit capteur d'image étant en outre conçu pour :
convertir le signal de luminance, le premier signal de couleur et le second signal de couleur en signaux numériques ;
générer sélectivement des données d'image possédant l'un d'une pluralité de formats d'image numériques sur la base d'un signal de luminance numérisé, du premier signal de couleur et du second signal de couleur ; et
délivrer en sortie les données d'image externes au capteur d'image.

15. Appareil électronique comprenant :
un ensemble lentille conçu pour former une image optique d'un sujet ;
un capteur d'image selon une quelconque revendication précédente conçu pour convertir l'image optique formée par l'ensemble lentille en un signal électrique ; et
un processeur conçu pour traiter le signal électrique généré par le capteur d'image.
